(19) Europäisches Patentamt
European Patent Office
Office européen des brevets

(11) Veröffentlichungsnummer: **0 085 024**
**B1**

# (12) EUROPÄISCHE PATENTSCHRIFT

(45) Veröffentlichungstag der Patentschrift: **15.07.87**

(51) Int. Cl.⁴: **G 03 F 7/10**

(21) Anmeldenummer: **83810016.2**

(22) Anmeldetag: **17.01.83**

(54) **Verfahren zur Erzeugung von Abbildungen in Photoresistschichten.**

(30) Priorität: **21.01.82 GB 8201726**

(43) Veröffentlichungstag der Anmeldung: **03.08.83 Patentblatt 83/31**

(45) Bekanntmachung des Hinweises auf die Patenterteilung: **15.07.87 Patentblatt 87/29**

(84) Benannte Vertragsstaaten: **BE CH DE FR GB IT LI NL SE**

(56) Entgegenhaltungen:
**EP - A - 0 035 969**
**FR - A - 2 322 897**
**GB - A - 1 330 100**
**US - A - 3 726 679**
**US - A - 4 220 707**
**US - A - 4 252 592**

(73) Patentinhaber: **CIBA-GEIGY AG, Klybeckstrasse 141, CH-4002 Basel (CH)**

(72) Erfinder: **Irving, Edward, Dr., 41, Swaffham ROad, Burwell Cambridge CB5 0AN (GB)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Vorliegende Erfindung betrifft ein Verfahren zur Erzeugung von Abbildungen unter Verwendung von photopolymerisierbaren Zusammensetzungen sowie eine nach diesem Verfahren hergestellte Abbildung tragende Substrate.

Die Herstellung von Abbildungen durch Photopolymerisation ist wohlbekannt. Dabei wird eine photopolymerisierbare Zusammensetzung als Überzug auf ein Substrat aufgebracht, welches häufig ein harzartiger, auf seiner Oberfläche ein Metall tragender Schichtkörper ist. Der Überzug wird durch ein Negativ oder eine sonstige Maske hindurch mit aktinischer Strahlung belichtet, und unbelichtete (und somit unpolymerisierte) Teile des Überzugs werden mittels eines geeigneten Lösungsmittels entfernt. Danach kann das Substrat geätzt werden, wobei nur die Teile der Metalloberfläche entfernt werden, die keinen photopolymerisierten Überzug tragen. Solche Abbildungen erzeugende Verfahren sind beispielsweise bei der Herstellung von Druckplatten und Leiterplatten nützlich. Photopolymerisierbare Zusammensetzungen enthalten häufig ein Epoxidharz als polymerisierbare Komponente.

Benzoide Polyamine, d.h. mehr als zwei an Stickstoffatome, die ihrerseits direkt an Kohlenstoffatomen in benzoiden Ringen stehen, gebundene Wasserstoffatome enthaltende Verbindungen, werden häufig zur Härtung von Epoxidharzen eingesetzt. Es ist üblich, dabei saure Beschleuniger wie Salicylsäure oder Maleinsäure-2-methoxyäthylhalbester zu verwenden, um die zur Erhitzung des Epoxidharzes mit dem benzoiden Polyamin zwecks Härtung erforderliche Zeit zu verkürzen; in Gegenwart einer Säure findet jedoch sogar bei Raumtemperatur bis zu einem gewissen Grad eine Reaktion zwischen dem Epoxidharz und dem Polyamin statt, so dass die Beschleunigung mit einer verringerten Lagerfähigkeit der härtbaren Zusammensetzung erkauft wird.

Es wurde nun gefunden, dass man in einem Gemisch aus einem Epoxidharz und einem benzoiden Polyamin durch Einbau bestimmter Substanzen und gewünschtenfalls Belichtung des Gemischs mit aktinischer Strahlung eine Säure erzeugen kann. Da diese Substanzen in Abwesenheit solcher Strahlung sich nicht wie Säuren verhalten, besitzen die Gemische ausreichende Lagerfähigkeit. Die bestrahlten Gemische können dann erhitzt werden, um rasche Härtung zu bewirken. Es wurde ferner gefunden, dass man die Beschleunigungswirkung auf die von der Strahlung getroffenen Teile des Gemischs beschränken kann; die so nicht getroffenen Teile härten viel langsamer, so dass unterschiedliche Härtung durch Anwendung einer Erhitzungsstufe von geeigneter Länge erzielbar ist. Überraschenderweise lässt sich die Beschleunigungswirkung in einer Schicht des Gemischs sehr genau auf bestrahlte Stellen beschränken, d.h. die freigesetzte Säure diffundiert im wesentlichen nicht in danebenliegende unbestrahlte Stellen, so dass es möglich ist, durch Belichtung mit aktinischer Strahlung wie durch ein Negativ hindurch scharfe Abbildungen zu erzeugen, wenn man nachträglich die ungehärteten, unbelichteten Stellen des Gemischs mit einem geeigneten Lösungsmittel auflöst oder auswäscht, wobei die gehärteten, belichteten Stellen der Wirkung des Lösungsmittels widerstehen.

Gegenstand dieser Erfindung ist demnach ein Verfahren zur Erzeugung von Abbildungen auf einem Substrat, wobei eine Schicht einer Photoresistzusammensetzung auf dem Substrat bildweise mit aktinischer Strahlung belichtet wird, die Zusammensetzung auf dem Substrat erhitzt wird, so dass der bzw. die von der Strahlung getroffene(n) Teil(e) der Zusammensetzung weitgehend gehärtet werden, während deren nicht so getroffene(r) Teil bzw. Teile weitgehend ungehärtet bleiben, und dann die Zusammensetzung auf dem Substrat mit einem Lösungsmittelentwickler behandelt wird, um den bzw. die weitgehend ungehärtet gebliebenen Teil(e) zu entfernen, und wobei die Photoresistzusammensetzung ein Epoxidharz und eine wirksame Menge eines benzoiden Polyamins enthält, dadurch gekennzeichnet, dass sie ausserdem eine wirksame Menge einer aromatischen Verbindung enthält, die bei Belichtung mit aktinischer Strahlung eine Säure freisetzt und unter (a) Chloriden, Bromiden und Jodiden von Oniumbasen der Elemente aus Gruppe VA, VIA oder VIIA des Periodensystems, (b) N-Sulfonyloxyimiden und Sulfonsäureestern mit β-Hydroxypropiophenonen oder o-Hydroxyacylphenonen, (c) o-Nitrobenzaldehyden und (d) α-Chloracylphenonen und α-Bromacylphenonen ausgewählt ist.

Die Begriffe «Aromatisch» und dessen Formen wie «Arylen» werden hier in ihrem allgemeineren Sinne verwendet und sollen sich nicht nur auf benzoide Kerne sondern auch auf jegliche Kerne mit $2+4n$ $\pi$-Elektronen, z.B. Pyridylkerne, beziehen.

In der britischen Patentschrift Nr. 1 508 951 der Anmelderin wurde eine Methode zur Herstellung von Präpregs, d.h. faserverstärkten, heisshärtbaren Harzverbundstoffen, beschrieben, welche darin besteht, dass man

i) ein faseriges Verstärkungsmaterial mit einer ein Epoxidharz und einen Photopolymerisationskatalysator dafür enthaltenden flüssigen Zusammensetzung und mit einem thermisch aktivierbaren Vernetzungsmittel für Epoxidharz imprägniert und

ii) das imprägnierte Material mit aktinischer Strahlung belichtet, so dass die Zusammensetzung sich durch Photopolymerisation des Epoxidharzes über dessen Epoxidgruppen verfestigt, wobei jedoch das Harz weitgehend im heisshärtbaren Zustand verbleibt.

Zur gewünschten Zeit wird der Präpreg erhitzt, um die Härtung des Harzes zu bewirken.

Bei jenem Verfahren zur Herstellung von Präpregs einsetzbare Photopolymerisationskatalysatoren sind unter anderem aromatische Oniumsalze, die bei der Belichtung mit aktinischer Strahlung eine Säure freisetzen, insbesondere Diazonium-, Arsonium-, Phosphonium-, Sulfonium-, Selenonium- und Jodoniumkomplexsalze, insbesondere die Tetrafluoroborate und Hexafluorophosphate. Das thermisch aktivierbare Vernetzungsmittel kann ein benzoides Polyamin wie Bis-(4-aminophenyl)-methan sein.

In der damit verwandten britischen Patentschrift Nr. 1 587 536 der Anmelderin wurde ein ähnliches Verfahren zur Herstellung von Präpregs beschrieben, bei dem eine solche Zusammensetzung mit aktinischer Strahlung belichtet wird, bevor sie mit den Fasern in Berührung gebracht wird, nämlich indem man

i) eine Schicht einer ein Epoxidharz als einzige photopolymerisierbare Komponente und einen hitzeaktivierbaren Härter für Epoxidharze enthaltende flüssige Zusammensetzung mit aktinischer Strahlung belichtet, bis diese Zusammensetzung sich unter Bildung eines im wesentlichen festen durchgehenden Films durch Photopolymerisation des Epoxidharzes über dessen Epoxidgruppen verfestigt, wobei jedoch das Epoxidharz im wesentlichen im heisshärtbaren Zustand verbleibt, und

ii) den so gebildeten Film und das faserige Verstärkungsmaterial unter solchen Bedingungen zusammenbringt, dass dieser film um die Fasern herumfliesst und die Komponenten dieses Films und die Fasern eine zusammenhängende Struktur bilden.

Danach wird der Präpreg zur Härtung des Harzes erhitzt.

In einer dritten britischen Patentschrift, Nr. 1 587 159, der Anmelderin, wurde ein Verfahren beschrieben, bei dem ähnliche Zusammensetzungen verwendet werden: dabei handelt es sich um eine Methode zum Verkleben zweier Oberflächen, welche darin besteht, dass man

i) eine Schicht einer ein Epoxidharz als einzige photopolymerisierbare Komponente und einen hitzeaktivierbaren Härter für Epoxidharze enthaltende flüssige Zusammensetzung mit aktinischer Strahlung belichtet, bis diese Zusammensetzung sich unter Bildung eines im wesentlichen festen durchgehenden Films durch Photopolymerisation des Epoxidharzes über dessen Epoxidgruppen verfestigt, wobei jedoch das Epoxidharz im wesentlichen im heisshärtbaren Zustand verbleibt, und

ii) den so gebildeten Film zwischen die beiden Oberflächen und in Berührung damit einbringt und zwecks Härtung des Harzes den Aufbau erhitzt.

Dass eine Säure zur Beschleunigung der Härtung eines Epoxidharzes mit einem aromatischen Polyamin durch photolytische Mittel an Ort und Stelle freigesetzt und so die Grundlage für ein Verfahren zur Erzeugung von Abbildungen abgeben könnte, ist unerwartet. In der britischen Patentschrift Nr. 1 330 100 ist ein Verfahren zur Herstellung von gedruckten Schaltungen beschrieben, bei dem man stufenweise einen Träger mit einer ein Epoxidharz mit einem Epoxidäquivalentgewicht von 800 bis 2 000, einen Aminhärter (gegebenenfalls ein benzoides Polyamin), ein halogeniertes Polycarbonsäureanhydrid und ein halogeniertes Kohlenwasserstofflösungsmittel enthaltenden Zusammensetzung beschichtet, den Überzug in einem vorbestimmten Muster mit Ultraviolettstrahlung belichtet, zwecks Härtung der unbelichteten Stellen erhitzt und zur Entfernung der belichteten Stellen des Überzugs entwickelt.

Es ist ohne weiteres ersichtlich, dass das in der oben erwähnten Patentschrift Nr. 1 330 100 beschriebene Verfahren der Herstellung positiver Abbildungen dient, während es sich bei vorliegender Erfindung um ein Verfahren zur Herstellung negativer Resists handelt. In der Patentschrift Nr. 1 330 100 wird als Annahme angegeben, dass Chlorendicanhydrid, d.h. 1,2,3,4,7,7-Hexachlorbicyclo[2.2.1]hept-5-en-2,3-dicarbonsäureanhydrid – das einzige halogenierte Polycarbonsäureanhydrid, dessen Verwendung erläutert ist – die Heisshärtung an den mit ultravioletter Strahlung belichteten Stellen stört. Jener Patentinhaber vermutete, dass Chlorendicanhydrid bei der Photolyse geringe Mengen Chlorwasserstoff freisetzen kann, die mit dem Aminhärter ein Salz bilden können, das zur Heisshärtung weniger reaktionsfähig ist, wodurch sich eine unterschiedliche Löslichkeit zwischen den belichteten und unbelichteten Stellen ergibt. Nach einer anderen vorgeschlagenen Erklärung findet die Reaktion der Epoxidgruppen im Epoxidharz mit Chlorwasserstoff oder Chlorendicanhydrid an den photolysierten Stellen statt, was die Heisshärtungsgeschwindigkeit verlangsamt.

Die Beschleunigung der an den belichteten Stellen stattfindenden Heisshärtung, ein wesentliches Merkmal der vorliegenden Erfindung bei Anwendung bestimmter Verbindungen, einschliesslich solcher, von denen angenommen wird, dass sie Chlorwasserstoff oder andere Säuren bilden, steht somit im Widerspruch zu den Voraussagen gemäss den Offenbarungen der oben erwähnten britischen Patentschrift Nr. 1 330 100.

Zur Verwendung bevorzugte Epoxidharze sind solche, die mindestens eine direkt an ein Sauerstoffatom gebundene Gruppe der Formel

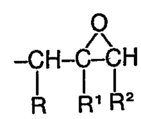

I

worin entweder R und $R^2$ je für ein Wasserstoffatom stehen, in welchem Fall $R^1$ ein Wasserstoffatom oder eine Methylgruppe bedeutet, oder R und $R^2$ zusammen $-CH_2CH_2-$ darstellen, in welchem Fall $R^1$ ein Wasserstoffatom bedeutet, enthalten.

Als Beispiele solcher Harze seien Polyglycidyl- und Poly-(β-methylglycidyl)-ester genannt, die man durch Umsetzung einer zwei oder mehr Carbonsäuregruppen pro Molekül enthaltenden Verbindung mit Epichlorhydrin, Glycerindichlorhydrin oder β-Methylepichlorhydrin in Gegenwart von Alkali erhalten kann. Solche Polyglycidylester können sich von aliphatischen Polycarbonsäuren, z.B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäuren wie Tetrahydrophthalsäure, 4-Methyltetrahydrophthalsäure, Hexahydrophthalsäure und 4-Methylhexahydrophthalsäure sowie von aromatischen Polycarbonsäuren, wie Phthalsäure, Isophthalsäure und Terephthalsäure ableiten. Weitere geeignete Polyglycidylester sind durch Vinylpolymerisation der Glycidylester von Vinylsäuren, insbesondere Glycidylacrylat und Glycidylmethacrylat, erhältlich.

Weitere Beispiele sind Polyglycidyl und Poly-(β-methylglycidyl)-äther, die durch Umsetzung einer mindestens zwei freie alkolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung, erhältlich sind. Diese Äther lassen sich aus acyclischen Alkoholen wie Äthylenglykol, Diäthylenglykol und höheren Poly-(oxyäthylen)-glykolen, Propan-1,2-diol und Poly-(oxypropylen)-glykolen, Propan-1,3-diol, Poly-(oxytetramethylen)-glykolen, Pentan-1,5-diol, Hexan-2,4,6-triol, Glycerin, 1,1,1-Trimethylolpropan, Pentaerythrit, Sorbit und Polyepichlorhydrinen, aus cycloaliphatischen Alkoholen wie Resorcit, Chinit, Bis-(4-hydroxycyclohexyl)-methan, 2,2-Bis-(4-hydroxycyclohexyl)-propan und 1,1-Bis-(hydroxymethyl)-cyclohex-3-en sowie aus Alkoholen mit aromatischen Kernen wie N,N-Bis-(2-hydroxyäthyl)-anilin und p,p'-Bis-(2-hydroxyäthylamino)-diphenylmethan herstellen. Man kann sie ferner aus einkernigen Phenolen wie Resorcin und Hydrochinon und mehrkernigen Phenolen wie Bis-(4-hydroxyphenyl)-methan, 4,4'-Dihydroxydiphenyl, Bis-(4-hydroxyphenyl)-sulfon, 1,1,2,2-Tetrakis-(4-hydroxyphenyl)-äthan, 2,2-Bis-(4-hydroxyphenyl)-propan, 2,2-Bis-(3,5-dibrom-4-hydroxyphenyl)-propan sowie aus Aldehyden wie Formaldehyd, Acetaldehyd, Chloral und Furfurol, mit Phenol selbst und durch Chloratome oder Alkylgruppen mit jeweils bis zu neun Kohlenstoffatomen ringsubstituiertem Phenol wie 4-Chlorphenol, 2-Methylphenol und 4-tert.-Butylphenol gebildeten Novolaken herstellen.

Epoxidharze mit mindestens einer Gruppe der Formel I, worin R und $R^2$ zusammen zusammen eine $-CH_2CH_2$-Gruppe darstellen, sind beispielsweise Bis-(2,3-epoxycyclopentyl)-äther, 2,3-Epoxycyclopentyl-glycidyläther und 1,2-Bis-(2,3-epoxycyclopentyloxy)-äthan.

In Betracht kommen auch Epoxidharze, in welchen die 1,2-Epoxidgruppen an Sauerstoffatome verschiedener Art gebunden sind, z.B. der Glycidyläther/Glycidylester der Salicylsäure.

Ebenfalls einsetzbar sind auch Epoxidharze, in denen einige oder sämtliche Epoxidgruppen mittelständig sind, wie Vinylcyclohexendioxyd, Limonendioxyd, Dicyclopentadiendioxyd, 4-Oxatetracyclo[6.2.1.$0^{2,7}$.$0^{3,5}$]undec-9-yl-glycidyläther, 1,2-Bis-(4-oxatetracyclo[6.2.1.$0^{2,7}$.$0^{3,5}$]undec-9-yloxy)-äthan, der 3,4-Epoxycyclohexylmethylester der 3',4'-Epoxycyclohexancarbonsäure sowie dessen 6,6'-Dimethylderivat, der Bis-(3,4-epoxycyclohexancarbonsäureester) des Äthylenglykols, 3-(3,4-Epoxycyclohexyl)-8,9-epoxy-2,4-dioxaspiro-[5.5]undecan sowie epoxidierte Butadiene oder Copolymere von Butadienen mit Äthylenverbindungen wie Styrol und Vinylacetat.

Gewünschtenfalls kann man Epoxidharzgemische verwenden.

Besonders bevorzugte, bei dem erfindungsgemässen Verfahren verwendete Epoxidharze sind gegebenenfalls vorverlängerte Polyglycidyläther von zweiwertigen, dreiwertigen oder vierwertigen Phenolen, z.B. 2,2-Bis-(4-hydroxyphenyl)-propan, Bis-(4-hydroxyphenyl)-methan und 1,1,2,2-Tetrakis-(4-hydroxyphenyl)-äthan, und von zweiwertigen oder dreiwertigen aliphatischen Alkoholen, z.B. Butan-1,4-diol und Hexan-2,4,6-triol.

Zur Verwendung als Heisshärter geeignete benzoide Polyamine sind unter anderem o-, m- und p-Phenylendiamin, Bis-(4-aminophenyl)-methan, Anilin/Formaldehydharze, Bis-(4-aminophenyl)-äther, Bis-(4-aminophenyl)-keton, Bis-(4-aminophenyl)-sulfid, Bis-(3-aminophenyl)-sulfon und Bis-(4-aminophenyl)-sulfon.

Die Quelle für die photolytisch freigesetzte Säure kann, wie schon angegeben, ein Chlorid, Bromid oder Jodid einer Oniumbase der Nichtmetallelemente aus den A-Untergruppen in Gruppe V, VI und VII des Periodensystems (wie auf Seite 60–61 in Handbook of Chemistry [Handbuch der Chemie], Lange, revidierte zehnte Auflage, Verlag McGraw-Hill, dargestellt) sein, insbesondere Diazonium-, Phosphonium-, Arsonium-, Oxonium-, Sulfonium-, Sulfoxonium-, Selenonium-, Telluronium-, Chloronium-, Bromonium- und Jodoniumchloride, -bromide oder -jodide.

In Frage kommende Jodoniumsalze sind dabei unter anderem solche der Formel

$$\left[Ar^1-\overset{+}{I}-Ar^2\right] X^- \qquad II$$

worin $Ar^1$ und $Ar^2$ unabhängig voneinander für gegebenenfalls durch eine oder mehrere Alkylgruppen mit 1 bis 8 Kohlenstoffatomen, Phenyl, Phenoxy, Halogen, Nitro oder eine oder mehrere Alkoxygruppen mit je 1 bis 4 Kohlenstoffatomen substituiertes Phenyl oder Naphthyl stehen oder $Ar^1$ und $Ar^2$ zusammen eine Gruppe der Formel

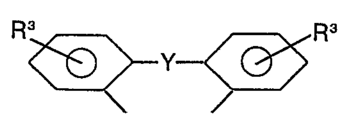

III

darstellen, worin $R^3$ für eine Alkylgruppe mit 1 bis 4 Kohlenstoffatomen, ein Halogenatom, eine Nitrogruppe oder eine Alkoxygruppe mit 1 bis 4 Kohlenstoffatomen und Y für eine Kohlenstoff-Kohlenstoffbindung, ein Sauerstoffatom oder eine Gruppe der Formel $-CH_2-$ oder $-CO-$ stehen, sowie $X^-$ ein Chlorid-, Bromid, oder Jodidanion bedeutet.

Jodoniumsalze der Formel II und deren Verwendung bei der Photopolymerisation kationisch polymerisierbarer Materialien sind in der britischen Patentschrift Nr. 1 539 192 beschrieben.

Spezielle Beispiele für geeignete Jodoniumsalze der Formel II sind unter anderem Diphenyljodoniumchlorid, Diphenyljodoniumjodid, Di-(p-To-

lyl)-jodoniumchlorid, Di-(4-nitrophenyl)-jodoniumchlorid, Di-(4-tert.-butylphenyl)-jodoniumchlorid, Di-2-naphthyljodoniumbromid, Di-(3-methoxyphenyl)-jodoniumchlorid, Diphenyl-2,2'-diyljodoniumchlorid, Diphenylmethan-2,2'-diyljodoniumchlorid und Di-(4-chlorphenyläther)-2,2'-diyljodoniumchlorid.

Dabei verwendbare Sulfoniumsalze sind unter anderem solche der Formel

$$Ar^3{}_a R^4{}_b R^5{}_c \overset{+}{S} \quad X^- \qquad IV$$

worin $Ar^3$ für eine einwertige aromatische Gruppe mit 6 bis 20 Kohlenstoffatomen, $R^4$ für eine Alkylgruppe mit 1 bis 6 Kohlenstoffatomen oder eine Cycloalkylgruppe mit 3 bis 6 Kohlenstoffatomen, wobei die Alkyl- oder Cycloalkylgruppe gegebenenfalls durch eine Alkoxygruppe mit 1 bis 4 Kohlenstoffatomen oder eine Alkoxycarbonylgruppe mit 2 bis 5 Kohlenstoffatomen substituiert ist, $R^5$ für einen mehrwertigen aliphatischen oder aromatischen Rest mit 3 bis 6 Kohlenstoffatomen, der eine heterocyclische oder kondensierte Ringstruktur bildet, a für 0, 1, 2 oder 3, b für 0, 1 oder 2 und c für 0 oder 1 stehen, wobei die Summe (a + b + c) 3 oder die Wertigkeit des Schwefelatoms beträgt, und $X^-$ die oben angegebene Bedeutung hat.

Sulfoniumsalze der Formel IV und deren Verwendung bei der Photopolymerisation von mit Säuren polymerisierbaren oder härtbaren Materialien sind in der britischen Patentschrift Nr. 1 526 923 beschrieben.

Spezielle Beispiele für geeignete Sulfoniumsalze der Formel IV sind unter anderem Triphenylsulfoniumbromid, Triphenylsulfoniumchlorid, Triphenylsulfoniumjodid, Diphenyläthylsulfoniumchlorid, Phenacyldimethylsulfoniumchlorid, Phenacyltetrahydrothiopheniumchlorid, p-Nitrophenacyltetrahydrothiopheniumchlorid und 4-Hydroxy-2-methylphenylhexahydrothiopyryliumchlorid.

Verwendbare Sulfoxoniumsalze sind unter anderem die Aryl- und Aracylsulfoxoniumsalze der Formel

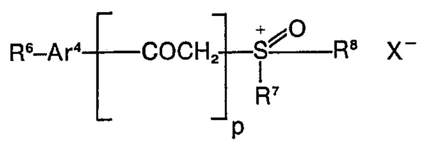
V

worin p für null oder 1, $Ar^4$ für eine Arylen- oder Aralkylengruppe mit 4 bis 25 Kohlenstoffatomen, welche bei p = 0 direkt über eines ihrer Kohlenstoffatome an das angegebene Schwefelatom bzw. bei p = 1 an das angegebene Carbonylkohlenstoffatom gebunden ist, $R^6$ für einen Wasserstoffatom oder eine Gruppe der Formel

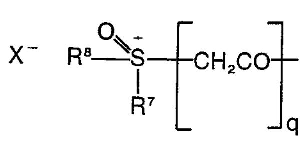
VI

und $R^7$ für eine Alkylgruppe mit 1 bis 18 Kohlenstoffatomen, eine Alkenylgruppe mit 2 bis 6 Kohlenstoffatomen, eine Cycloalkylgruppe mit 3 bis 4 Kohlenstoffatomen, eine Cycloalkylalkylgruppe mit 4 bis 8 Kohlenstoffatomen, eine Arylgruppe mit 4 bis 24 Kohlenstoffatomen oder eine Aralkylgruppe mit 5 bis 16 Kohlenstoffatomen stehen, $R^8$ dieselbe Bedeutung wie $R^7$ hat, aber auch eine Dialkylaminogruppe mit 2 bis 6 Kohlenstoffatomen oder, falls $R^7$ eine Alkylgruppe wie oben bedeutet, auch eine Arylaminogruppe mit 4 bis 8 Kohlenstoffatomen darstellen kann, q bei p = 0 null oder bei p = 1 null oder 1 ist und $X^-$ die oben angegebene Bedeutung hat.

Sulfoxoniumsalze der Formel V und Verfahren zu ihrer Herstellung sind in der europäischen Patentanmeldung Nr. 0 035 969 beschrieben, wie auch ihre Verwendung zur Umwandlung von kationisch polymerisierbaren Substanzen in Stoffe höheren Molekulargewichts durch Photopolymerisation.

Spezielle Beispiele für geeignete Sulfoxoniumsalze der Formel VI sind unter anderem Dimethylphenylsulfoxoniumchlorid, Dimethylphenacylsulfoxoniumbromid, Dimethylphenacylsulfoxoniumchlorid, Diphenylphenacylsulfoxoniumbromid, 1,4-Bis-(1-oxo-2-(dimethylsulfoxonium)-äthyl)-benzoldichlorid, (Dimethylamino)-diphenylsulfoxoniumchlorid und Triphenylsulfoxoniumchlorid.

Als weitere Sulfoxoniumsalze eignen sich auch die Carbamoylsulfoxoniumsalze der Formel

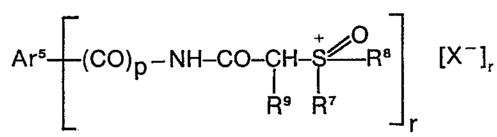
VII

worin p, $R^7$, $R^8$ und $R^9$ die unter Formel V angegebenen Bedeutungen haben, r 1 oder 2 ist, $Ar^5$ für eine r-wertige aromatische Gruppe mit 4 bis 25 Kohlenstoffatomen, welche bei p = 1 direkt über eines ihrer Kohlenstoffatome an das Kohlenstoffatom der angegebenen, danebenliegenden Carbonylgruppe bzw. bei p = null an das angegebene Stickstoffatom gebunden ist, und $R^9$ für ein Wasserstoffatom oder eine Gruppe der Formel

$$-COR^{11} \qquad VIII$$

oder

$$-CO-NH-(CO)_t-R^{12} \qquad IX$$

stehen, worin $R^{11}$ einen einwertigen, direkt über eines seiner Kohlenstoffatome an die in der Formel VIII gezeigte -CO-Gruppe gebundenen, gesättigten oder äthylenisch ungesättigten Rest mit 1 bis 12 Kohlenstoffatomen, t null oder 1 und $R^{12}$ einen einwertigen, gesättigten oder äthylenisch ungesättigten Rest mit 1 bis 12 Kohlenstoffatomen bedeuten, welcher bei t = null direkt über eines seiner Kohlenstoffatome an das angegebene Stickstoffatom bzw. bei t = 1 an das Kohlenstoffatom der angegebenen, danebenliegenden Carbonylgruppe gebunden ist.

Sulfoxoniumsalze der Formel VII und Verfahren zu ihrer Herstellung sind in der europäischen Patentanmeldung Nr. 0 044 274 beschrieben, wie auch ihre Verwendung der Umwandlung kationisch polymerisierbarer Substanzen in Stoffe höheren Molekulargewichts durch Photopolymerisation.

Spezielle Beispiele für geeignete Carbamoylsulfoxoniumsalze der Formel VII sind unter anderem Acetanilinodimethylsulfoxoniumchlorid und -bromid, 3,4-Dichloracetanilinodimethylsulfoxoniumchlorid, p-Methylacetanilinodimethylsulfoxoniumchlorid, Benzoylcarbamoyldimethylsulfoxoniumchlorid, p-Chloracetanilinodimethylsulfoxoniumchlorid und 2,4-Bis-(dimethylsulfoxoniummethylcarbamoyl)-toluolchlorid.

Weitere als Säurequelle geeignete aromatische Verbindungen sind unter anderem Substanzen, die bei der Photolyse Sulfonsäure erzeugen, nämlich N-Sulfonyloxyimide und -ester von Sulfonsäuren mit β-Hydroxypropiophenonen oder mit o-Hydroxyacylphenonen.

Als N-Sulfonyloxyimide eignen sich unter anderem solche der Formel

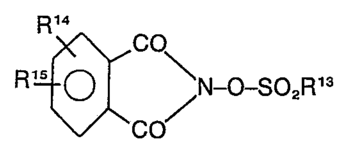

X

oder der Formel

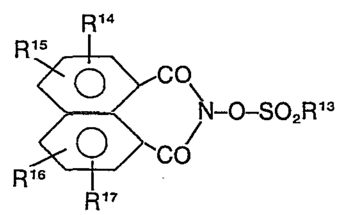

XI

worin $R^{13}$ für eine Alkylgruppe mit 1 bis 12 Kohlenstoffatomen, eine gegebenenfalls durch eine Alkylgruppe mit 1 bis 12 Kohlenstoffatomen, eine Alkoxygruppe mit 1 bis 4 Kohlenstoffatomen, ein Halogenatom, eine Nitrogruppe, eine Alkylcarbamoylgruppe mit insgesamt 2 bis 5 Kohlenstoffatomen oder eine Phenylcarbamoylgruppe substituierte Phenylgruppe, ein mit gegebenenfalls durch eine Alkylgruppe mit 1 bis 12 Kohlenstoffatomen oder ein Halogenatom substituierte Naphthylgruppe, eine Cycloalkylgruppe mit 5 bis 7 Kohlenstoffatomen oder eine Gruppe der Formel $-CF_3$, $CCl_3$ oder $-CH_2Cl$ sowie $R^{14}$ bis $R^{17}$ unabhängig voneinander je für Wasserstoff, eine Alkylgruppe mit 1 bis 8 Kohlenstoffatomen, eine Alkoxygruppe mit 1 bis 4 Kohlenstoffatomen, eine Alkylthiogruppe mit 1 bis 12 Kohlenstoffatomen, eine Phenylthiogruppe, eine Nitrogruppe oder ein Halogenatom stehen.

Solche N-Sulfonyloxyimide für die Photopolymerisation von mindestens zwei äthylenisch ungesättigte Gruppen enthaltenden Verbindungen sind in der U.S. Patentschrift Nr. 4 258 121 beschrieben.

Spezielle Beispiele für geeignete N-Sulfonyloxyimide der Formel X oder XI sind unter anderem N-(Phenylsulfonyloxy)-phthalimid, N-(Toluol-p-sulfonyloxy)-phthalimid, N-(Phenylsulfonyloxy)-1,8-naphthalimid, N-(Naphthalin-1-sulfonyloxy)-phthalimid und N-(Methylsulfonyloxy)-phthalimid.

Geeignete Ester von Sulfonsäuren mit β-Hydroxypropiophenonen sind unter anderem solche der Formel

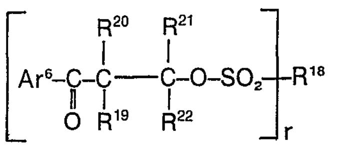

XII

worin r die oben angegebene Bedeutung hat, $Ar^6$ für eine gegebenenfalls durch eine oder mehrere Alkyl- oder Alkoxygruppen mit 1 bis 8 Kohlenstoffatomen, ein oder mehrere Halogenatome oder eine gegebenenfalls durch eine Hydroxylgruppe substituierte Dialkylaminogruppe mit je 1 bis 4 Kohlenstoffatomen in den Alkylgruppen substituierte aromatische Gruppe mit 6 bis 14 Kohlenstoffatomen, $R^{18}$ bei $r = 1$ für eine Alkylgruppe mit 1 bis 18 Kohlenstoffatomen, eine Alkenylgruppe mit 2 bis 18 Kohlenstoffatomen, eine Cycloalkyl- oder Cycloalkenylgruppe mit 5 bis 18 Kohlenstoffatomen, eine gegebenenfalls durch ein Chloratom, eine Hydroxylgruppe, eine Alkylgruppe mit 1 bis 12 Kohlenstoffatomen oder eine Alkoxygruppe mit 1 bis 4 Kohlenstoffatomen substituierte Arylgruppe mit 6 bis 12 Kohlenstoffatomen, eine Cycloalkylgruppe mit 5 bis 6 Kohlenstoffatomen, eine Aralkylgruppe mit 7 bis 9 Kohlenstoffatomen, Trifluormethyl, Fluor oder eine Aminogruppe sowie bei $r = 2$ für eine Gruppe $-(CH_2)_n-$, wobei n eine ganze Zahl von 2 bis 8 ist, oder eine gegebenenfalls durch eine Alkyl- oder Alkylengruppe mit 1 bis 12 Kohlenstoffatomen substituierte Phenylen- oder Aralkylengruppe, $R^{19}$ für ein Wasserstoffatom, eine Alkylgruppe mit 1 bis 18 Kohlenstoffatomen, eine Alkenylgruppe mit 2 bis 18 Kohlenstoffatomen, eine Trimethylsilylgruppe, eine Acetylgruppe, eine Cycloalkyl- oder Cycloalkenylgruppe mit 5 bis 8 Kohlenstoffatomen, eine Arylgruppe mit 6 bis 20 Kohlenstoffatomen, eine Furfurylgruppe oder eine Gruppe $-CH(R^{23})OR^{24}$, in der $R^{23}$ eine Methylgruppe und $R^{24}$ eine Alkylgruppe mit 2 bis 4 Kohlenstoffatomen oder $R^{23}$ und $R^{24}$ zusammen eine gegebenenfalls durch eine Alkoxygruppe mit 1 bis 4 Kohlenstoffatomen substituierte 1,3- oder 1,4-Alkylengruppe mit 3 bis 4 Kohlenstoffatomen darstellen, und $R^{20}$ für ein Wasserstoffatom, eine gegebenenfalls durch eine oder mehrere Alkyl- oder Alkoxygruppen mit 1 bis 4 Kohlenstoffatomen oder ein oder mehrere Halogenatome substituierte aromatische Gruppe mit 6 bis 14 Kohlenstoffatomen oder eine gegebenenfalls durch eine Phenylgruppe substituierte Alkylgruppe mit 1 bis 8 Kohlenstoffatomen stehen sowie $R^{21}$ und $R^{22}$ unabhängig voneinander je ein Wasserstoffatom, eine Alkylgruppe mit 1 bis 8 Kohlenstoffatomen oder eine gegebenenfalls

durch ein Chloratom, eine Hydroxylgruppe oder eine Alkyl- oder Alkoxygruppe mit 1 bis 4 Kohlenstoffatomen substituierte Phenylgruppe bedeuten können oder $R^{20}$ und $R^{21}$ zusammen mit dem Kohlenstoffatom, an das sie gebunden sind, einen 5- oder 6-gliedrigen carbocyclischen Ring bilden.

Besonders bevorzugte Verbindungen der Formel XII sind Sulfonsäureester von α-Methylolbenzoinen, der allgemeinen Formel

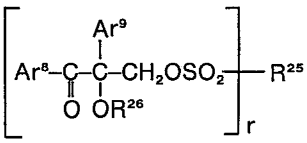
XIII

worin r die oben angegebene Bedeutung hat, $Ar^8$ und $Ar^9$ gleich oder verschieden sein können und je für eine gegebenenfalls durch eine oder mehrere Alkylgruppen mit 1 bis 4 Kohlenstoffatomen, eine oder mehrere Alkoxygruppen mit 1 bis 4 Kohlenstoffatomen oder ein oder mehrere Halogenatome substituierte aromatische Gruppe mit 6 bis 14 Kohlenstoffatomen, $R^{25}$ für eine Alkyl- oder Alkylengruppe mit 1 bis 6 Kohlenstoffatomen, eine Arylgruppe mit 6 bis 12 Kohlenstoffatomen oder eine Aralkylengruppe mit 6 bis 15 Kohlenstoffatomen und $R^{26}$ für ein Wasserstoffatom oder eine Alkylgruppe mit 1 bis 4 Kohlenstoffatomen stehen.

Als Verbindungen der Formel XII und XIII eignen sich beispielsweise α-Hydroxymethylbenzoinmethansulfonat, -benzolsulfonat, -toluol-p-sulfonat und -naphthalin-2-sulfonat, α-Hydroxymethyl-4,4'-dimethylbenzoin-benzolsulfonat, α-Hydroxymethylbenzoinisopropyläther-benzolsulfonat und 3-(p-Toluolsulfonyloxy)-2-hydroxy-2-methyl-1-phenyl-1-propanon. Viele dieser Verbindungen sind in der U.S. Patentschrift Nr. 3 732 273 und in der europäischen Patentanmeldung Nr. 0 037 152 beschrieben. Solche Verbindungen, die in keiner dieser Veröffentlichungen beschrieben sind, lassen sich durch Umsetzung eines Epoxids der Formel XIV mit einer Sulfon- oder Disulfonsäure der Formel XV oder XVI

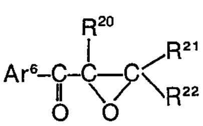
XIV

$R^{18}SO_3H$ XV

$HO_3S-R^{18}-SO_3H$ XVI

worin $Ar^6$, $R^{18}$, $R^{20}$, $R^{21}$ und $R^{22}$ die oben angegebenen Bedeutungen haben, herstellen. Diese Reaktion liefert ein Produkt der Formel XII, worin $R^{19}$ für ein Wasserstoffatom steht. Ein solches Produkt lässt sich nach bekannten Methoden oder Alkylierung usw. in ein anderes Produkt der Formel XII, worin $R^{19}$ von einem Wasserstoffatom verschieden ist, umwandeln.

Weitere geeignete Ester von Sulfonsäuren sind unter anderem solche von o-Hydroxyacylphenonen der allgemeinen Formel

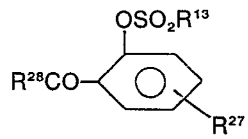
XVII

worin $R^{13}$ die unter Formeln X und XI angegebene Bedeutung hat sowie $R^{27}$ für ein Wasserstoffatom, ein Halogenatom, eine Nitrogruppe, eine Alkylgruppe mit 1 bis 12 Kohlenstoffatomen, eine Alkoxygruppe mit 1 bis 4 Kohlenstoffatomen oder eine Gruppe der Formel $-OSO_2R^{13}$ und $R^{28}$ für eine Alkylgruppe mit 1 bis 4 Kohlenstoffatomen, eine Phenylgruppe oder eine Gruppe der Formel

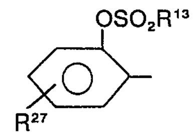
XVIII

stehen.

Spezielle Beispiele für Verbindungen der Formel XVII sind unter anderem 2-Hydroxybenzophenon-methansulfonat und 2,4-Hydroxybenzophenon-bis-(methansulfonat).

Die Herstellung und Verwendung solcher Verbindungen bei der kationischen Polymerisation sind von Pappas und Chiu-Wing Lam, J. Radiation Curing 1980 7 (1), 2–5, beschrieben.

Wie schon angegeben, lassen sich auch o-Nitrobenzaldehyde als aromatische Verbindungen, die bei Bestrahlung Säure freisetzten, einsetzen. Bei Bestrahlung mit aktinischer Energie lagern sich diese unter Bildung von o-Nitrosobenzoesäuren um (siehe z.B. britische Patentschrift Nr. 733 409). Geeignete o-Nitrobenzaldehyde sind unter anderem solche der Formel

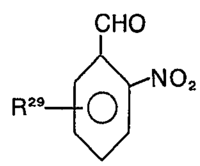
XIX

worin $R^{29}$ für ein Wasserstoffatom oder eine Nitrogruppe steht, insbesondere o-Nitrobenzaldehyd und 2,6-Dinitrobenzaldehyd.

Die vierte Gruppe von zur Verwendung als Säurequelle geeigneten aromatischen Verbindungen sind die α-Chloracylphenone und α-Bromacylphenone.

Zu bevorzugten α-Haloacylphenonen gehören solche der Formel

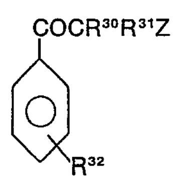
XX

worin Z für ein Chlor- oder Bromatom, $R^{30}$ und $R^{31}$ unabhängig voneinander je für ein Wasserstoff-, Chlor- oder Bromatom und $R^{32}$ für ein Wasserstoffatom, eine Alkylgruppe mit 1 bis 6 Kohlenstoffatomen oder eine Gruppe der Formel

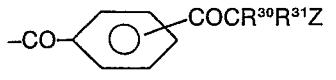

XXI

stehen.

Geeignete Verbindungen der Formel XX sind unter anderem α,α,α-Trichloracetophenon und p-tert.-Butyl-α,α,α-trichloracetophenon, die technisch als Photopolymerisationskatalysatoren im Einsatz stehen.

Üblicherweise soll die Zusammensetzung so viel benzoides Polyamin enthalten, dass 0,7 bis 1,1 aromatische Aminwasserstoffatome auf eine 1,2-Epoxidgruppe im Epoxidharz kommen. Die Menge der als Säurequelle dienenden aromatischen Verbindung richtet sich nach der Leistungsfähigkeit des Photolyseverfahrens, der Konstitution der Verbindung und der Menge aktinischer Energie, mit der die aromatische Verbindung belichtet wird. Geeignete Verhältnisse lassen sich leicht durch Serienversuche festlegen, doch verwendet man typischerweise 5 bis 30 und vorzugsweise 7 bis 25 Gew.-%, berechnet auf das Gewicht des Epoxidharzes.

Beim Bestrahlungsvorgang verwendet man vorzugsweise aktinische Strahlung einer Wellenlänge von 200 bis 600 nm. Als Strahlungsquellen eignen sich unter anderem Kohlelichtbögen, Quecksilberdampflichtbögen, Leuchtröhren mit ultraviolettes Licht aussendenden Leuchtstoffen, Argon- und Xenonglimmlampen, Wolframlampen und photographische Flutlampen. Von diesen sind Quecksilberdampflichtbögen, insbesondere Höhensonnen, fluoreszierende Höhensonnen und Metallhalogenidlampen am besten geeignet. Die erforderliche Belichtungszeit hängt dabei von verschiedenen Faktoren ab, einschliesslich z.B. dem jeweils verwendeten polymerisierbaren Substrat, der Art der Lichtquelle und deren Abstand vom bestrahlten Material.

Zur Heisshärtung werden die Zusammensetzungen vorzugsweise 2 bis 25 Minuten lang, üblicherweise 5 bis 15 Minuten, auf 100 °C bis 140 °C erhitzt.

Die Zusammensetzungen können vorzugsweise als Flüssigkeit auf ein Substrat wie Strahl, Aluminium, Kupfer, Cadmium, Zink, Papier oder Holz aufgebracht und bestrahlt und dann erhitzt werden. Belichtet man nur einen Teil bzw. Teile der Beschichtung durch eine Maske hindurch mit Strahlung und erhitzt dann, so können die nicht gehärteten Stellen mit einem Lösungsmittel wie Cyclohexanon, 2-Äthoxyäthanol, Toluol, Aceton und deren Gemischen weggelöst werden. Somit kann man die erfindungsgemässen Zusammensetzungen zur Herstellung von Druckplatten und gedruckten Schaltungen verwenden. Methoden zur Herstellung von Druckplatten und gedruckten Schaltungen aus photpolymerisierbaren Zusammensetzungen sind wohlbekannt.

Die nachfolgenden Beispiele erläutern die Erfindung. Falls nicht anders angegeben, sind Teile Gewichtsteile.

Epoxidharz I bezeichnet ein bromhaltiges festes Epoxidharz, das durch Vorverlängerung des Diglycidyläthers von 2,2-Bis-(p-hydroxyphenyl)-propan mit 2,2-Bis-(3,5-di-brom-4-hydroxyphenyl)-propan hergestellt wird; sein Epoxidgehalt ist 2,1 val/kg.

Epoxidharz II bezeichnet ein 1,1,2,2-Tetrakis-(p-hydroxyphenyl)-äthan-tetraglycidyläther und 2,2-Bis-(p-hydroxyphenyl)-propan-diglycidyläther enthaltendes Gemisch. Dies wird durch Kondensation von Glyoxal und Phenol (4 Mol) zur Bildung des Tetraphenols, Zusatz von 20 Gew.-% 2,2-Bis-(p-hydroxyphenyl)-propan, berechnet auf das Gewicht des Tetraphenols, und Glycidylierung mit Epichlorhydrin hergestellt. Es besitzt einen Epoxidgehalt von 5,0 val/kg.

Epoxidharz III bezeichnet einen Polyglycidyläther des 2,2-Bis-(p-hydroxyphenyl)-propans mit einem Epoxidgehalt von 1,6 val/kg und einem Erweichungspunkt (Duran) von 75° bis 85 °C.

Epoxidharz VI bezeichnet den Diglycidylester des 2,2-Bis-(4-(2-carboxycyclohexyloxycarbonyl)-cyclohexyl)-propans, gemäss der britischen Patentschrift Nr. 1 220 702 hergestellt. Es besitzt einen Expoxidgehalt von 3,0 val/kg.

Polyamin I bezeichnet einen im Handel erhältlichen, flüssigen Härter, der im wesentlichen aus Bis-(4-aminophenyl)-methan besteht; sein Amingehalt ist 17 NH-val/kg.

Polyamin II bezeichnet einen im Handel erhältlichen, flüssigen Härter, der im wesentlichen aus Bis-(4-aminophenyl)-methan mit Dibutylphthalat besteht; sein Amingehalt ist 4,9 NH-val/kg.

Beispiel 1

Eine aus 5 Teilen Epoxidharz I, 5 Teilen Epoxidharz II, 2 Teilen Polyamin I, 1 Teil α,α,α-Trichloracetophenon und 10 Teilen Cyclohexanon bestehende Zusammensetzung wird durch Schleuderbeschichtung bei 2 500 U.p.M. als dünner Überzug auf einen Kupferschichtkörper aufgebracht. Der Überzug wird durch ein 1 mm darüber gehaltenes Negativ hindurch 20 Minuten lang mit einer Mitteldruckquecksilberlampe (30 W pro cm) bestrahlt. Dann erhitzt man den Schichtkörper 10 Minuten auf 120 °C und lässt ihn abkühlen. Entwicklung mit Cyclohexanon liefert eine gute negative Abbildung, was zeigt, dass Härtung stattgefunden hat, wo der Überzug von der Strahlung getroffen wurde, dass jedoch die Zusammensetzung nicht gehärtet ist und im organischen Lösungsmittel löslich bleibt, wo sie durch dunkle Stellen im Negativ von der Belichtung abgeschirmt war.

Für Vergleichzwecke wird der Versuch unter Weglassung des Polyamins I wiederholt. Beim Entwickeln wird der Überzug völlig aufgelöst, ohne dass eine Abbildung sichtbar ist, was bestätigt, dass die Unlöslichmachung, d.h. Härtung, von der Gegenwart von Polyamin I abhängt und nicht ausschliesslich der Wirkung des α,α,α-Trichloracetophenons zuzuschreiben ist.

Der Versuch wird nochmals wiederholt, aber nun unter Weglassung des α,α,α-Trichloracetophenons. Beim Entwickeln ist eine sehr schwache Abbildung wahrnehmbar, doch löst sich der Überzug fast völlig, was bestätigt, dass Polyamin I unter den zur Härtung angewandten Bedingungen praktisch unwirksam ist.

Beispiel 2

Ein Kupferschichtkörper wird wie in Beispiel mit einer 10 Teile Epoxidharz I, je 5 Teile Epoxidharz II und Epoxidharz III, 4 Teile Polyamin II, 4 Teile o-Nitrobenzaldehyd und 20 Teile Cyclohexanon enthaltenden Zusammensetzung schleuderbeschichtet, und der Überzug wird dann zum Abtreiben verbleibenden Cyclohexanons 2 Minuten auf 50 °C erhitzt. Danach wird der Überzug durch ein in Berührung damit gehaltenes Negativ hindurch 20 Minuten mit einer Mitteldruckquecksilberlampe (30 W pro cm) bestrahlt und dann 15 Minuten auf 120 °C erhitzt. Beim Entwickeln mit Toluol entsteht eine klare Abbildung.

Bekanntlich lagert sich o-Nitrobenzaldehyd bei der Photolyse zu o-Nitrosobenzoesäure um. Als einwertige Säure kann diese nicht die Vernetzung (und Unlöslichmachung) von Epoxidharzen bewirken. Dies zeigt, dass die beobachtete Härtung nicht der direkten Wirkung des o-Nitrobenzaldehyds oder der an den belichteten Stellen daraus gebildeten Säure, sondern der kombinierten Wirkung des Polyamins II und der Säure zuzuschreiben ist.

Beispiel 3

Man verfährt wie in Beispiel 2, jedoch mit 8 Teilen Polyamin II, Beim Entwickeln mit einem Toluol/Acetongemisch (9:1 Vol.) wird eine klare Abbildung erhalten.

Beispiel 4

Man verfährt wie in Beispiel 1, jedoch unter Verwendung von 1,8 Teilen 50%iger wässriger Triphenylsulfoniumchloridlösung an Stelle von α,α,α-Trichloracetophenon. Entwicklung in Toluol/Aceton (9:1 Vol.) ergibt eine Abbildung.

Für Vergleichszwecke wird der Versuch unter Weglassung des Polyamins I wiederholt. Beim Entwickeln mit Toluol/Aceton (9:1 Vol.) ist eine sehr schwache Abbildung zu sehen, doch ist die Wirkung des Triphenylsulfoniumchlorids in Abwesenheit von Polyamin I ganz ungenügend zur Erzielung eines brauchbaren Ergebnisses, und beim Entwickeln mit Cyclohexanon an Stelle von Toluol/Aceton löst sich der Überzug völlig auf.

Beispiel 5

Man verfährt wie in Beispiel 1, jedoch unter Verwendung von 0,9 Teilen Diphenyljodoniumchlorid an Stelle von α,α,α-Trichloracetophenon und 4 Teilen Polyamin II an Stelle von Polyamin I. Beim Entwickeln mit Cyclohexanon entsteht eine klare Abbildung.

Für Vergleichszwecke wird der Versuch unter Weglassung des Polyamins I wiederholt. Beim Entwickeln mit entweder Toluol/Aceton (9:1 Vol.) oder Cyclohexanon löst sich der Überzug völlig auf, und es ist keine Abbildung zu beobachten.

Beispiel 6

Man verfährt wie in Beispiel 1, unter Verwendung eines 5 Teile Epoxidharz I, 5 Teile Epoxidharz II, 4 Teile Polyamin II und 1 Teil N-(Phenylsulfonyloxy)-1,8-naphthalimid in 10 Teilen N-Methylpyrrolidon enthaltenden Gemisches; nach der Bestrahlung wird der Schichtkörper nur 5 Minuten auf 120 °C erhitzt. Entwicklung in Toluol/Aceton (9:1 Vol.) liefert eine Abbildung, die der Ätzung mit einer Ätzflüssigkeit (41%ige wässrige Ferrichloridlösung) widersteht.

Zu Vergleichszwecken wird der Versuch wiederholt, jedoch unter Weglassung des n-(Phenylsulfonyloxy)-1,8-naphthalimids und mit 10 Minuten Erhitzen. Beim Entwickeln mit Toluol/Aceton (9:1 Vol.) ist trotz der Verdoppelung der Härtungszeit nur eine schwache Andeutung der Abbildung erkennbar, und mit Cyclohexanon löst sich der Überzug völlig auf.

Beispiel 7

Man verfährt wie im ersten Teil von Beispiel 6, jedoch unter Verwendung der gleichen Gewichtsmenge N-(Phenylsulfonyloxy)-phthalimid an Stelle des Naphthalimids; beim Entwickeln mit Cyclohexanon entsteht eine gute Abbildung.

Beispiel 8

Man verfährt wie in Beispiel 2, unter Einsatz von 5 Teilen Epoxidharz I, 5 Teilen Epoxidharz II, 2 Teilen Polyamin II, 2 Teilen Benzophenon-2-methansulfonat und 10 Teilen Cyclohexanon. Entwicklung in Toluol/Aceton (9:1 Vol.) ergibt eine Abbildung, die jedoch etwas verzerrt ist, da beim Erhitzen ein gewisses Fliessen des Überzugs eintrat.

Beispiel 9

Eine aus 10 Teilen Epoxidharz VI, 2 Teilen Bis-(4-aminophenyl)-sulfon, 1 Teil 3-(p-Toluolsulfonyloxy)-2-hydroxy-2-methyl-1-phenyl-1-propanon, 5 Teilen Aceton und 6 Teilen Cyclohexanon bestehende Zusammensetzung wird durch 1 Minute lange Schleuderbeschichtung bei 2 000 U.p.M. als dünner Überzug auf einen kupferkaschierten Schichtkörper aufgebracht. Der Überzug wird 2 Minuten bei 50 °C getrocknet, wobei ein klebfreier Lack verbleibt, und dann 5 Minuten unter Verwendung einer 5 000 W Mitteldruckmetallhalogenidlampe im Abstand von 75 cm durch ein Negativ hindurch bestrahlt.

Dann erhitzt man die bestrahlte Platte 10 Minuten auf 140 °C und lässt sie abkühlen. Entwicklung mit einem Toluol/Acetongemisch (80:20 Vol) liefert eine negative Abbildung.

**Patentansprüche**

1. Verfahren zur Erzeugung von Abbildungen auf einem Substrat, wobei eine Schicht einer Photoresistzusammensetzung auf dem Substrat bildweise mit aktinischer Strahlung belichtet wird, die Zusammensetzung auf dem Substrat erhitzt wird, so dass der bzw. die von der Strahlung getroffene(n) Teil(e) der Zusammensetzung weitgehend gehärtet werden, während deren nicht so getroffene(r) Teil bzw. Teile weitgehend ungehärtet bleiben, und dann die Zusammensetzung auf dem Substrat mit einem Lösungsmittelentwickler behandelt wird, um den bzw. die weitgehend ungehärtet gebliebenen Teil(e) zu entfernen, und wobei die Photoresistzusammensetzung ein Epoxidharz und eine wirksame Menge eines benzoiden Polyamins enthält, dadurch gekennzeichnet, dass sie ausserdem eine wirksame Menge einer aromatischen Verbindung enthält, die bei Belichtung mit aktinischer Strahlung eine Säure freisetzt und unter (a) Chloriden, Bromiden und Jodiden von Oniumbasen der Elemente aus Gruppe VA, VIA oder VIIA des Periodensystems, (b) N-Sulfonyloxyimiden und Sulfonsäureestern mit β-Hydroxypropiophenonen oder o-Hydroxyacylphenonen, (c) o-Nitrobenzaldehyden und (d) α-Chloracylphenonen und α-Bromacylphenonen ausgewählt ist.

2. Verfahren nach Anspruch 1, dadurch gekennzeichnet, dass das benzoide Polyamin o-, m- oder p-Phenylendiamin, Bis-(4-aminophenyl)-methan, ein Anilin/Formaldehydharz, Bis-(4-aminophenyl)-äther, Bis-(4-aminophenyl)-keton, Bis-(4-aminophenyl)-sulfid, Bis-(3-aminophenyl)-sulfon oder Bis-(4-aminophenyl)-sulfon ist.

3. Verfahren nach Anspruch 1 oder 2, dadurch gekennzeichnet, dass die aromatische Verbindung ein Diazonium-, Phosphonium-, Arsonium-, Oxonium-, Sulfonium-, Sulfoxonium-, Selenonium-, Telluronium-, Chloronium-, Bromonium- oder Jodoniumchlorid, -bromid oder -jodid ist.

4. Verfahren nach Anspruch 3, dadurch gekennzeichnet, dass die aromatische Verbindung ein Jodoniumsalz der Formel

$$\left[Ar^1-\overset{+}{I}-Ar^2\right]\ X^- \qquad II$$

ist, worin $Ar^1$ und $Ar^2$ unabhängig voneinander für gegebenenfalls durch eine oder mehrere Alkylgruppen mit 1 bis 8 Kohlenstoffatomen, Phenyl, Phenoxy, Halogen, Nitro oder eine oder mehrere Alkoxygruppen mit je 1 bis 4 Kohlenstoffatomen substituiertes Phenyl oder Naphthyl stehen oder $Ar^1$ und $Ar^2$ zusammen eine Gruppe der Formel

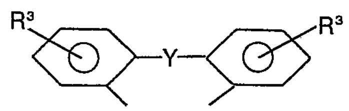 III

darstellen, worin $R^3$ für eine Alkylgruppe mit 1 bis 4 Kohlenstoffatomen, ein Halogenatom, eine Nitrogruppe oder eine Alkoxygruppe mit 1 bis 4 Kohlenstoffatomen und Y für eine Kohlenstoff-Kohlenstoffbindung, ein Sauerstoffatom oder eine Gruppe der Formel $-CH_2-$ oder $-CO-$ stehen, sowie $X^-$ ein Chlorid-, Bromid- oder Jodidanion bedeutet.

5. Verfahren nach Anspruch 3, dadurch gekennzeichnet, dass die aromatische Verbindung ein Sulfoniumsalz der Formel

$$Ar^3{}_aR^4{}_bR^5{}_c\overset{+}{S}\ X^- \qquad IV$$ ist,

worin $Ar^3$ für eine einwertige aromatische Gruppe mit 6 bis 20 Kohlenstoffatomen, $R^4$ für eine Alkylgruppe mit 1 bis 6 Kohlenstoffatomen oder eine Cycloalkylgruppe mit 3 bis 6 Kohlenstoffatomen, wobei die Alkyl- oder Cycloalkylgruppe gegebenenfalls durch eine Alkoxygruppe mit 1 bis 4 Kohlenstoffatomen oder eine Alkoxycarbonylgruppe mit 2 bis 5 Kohlenstoffatomen substituiert ist, $R^5$ für eine mehrwertigen aliphatischen oder aromatischen Rest mit 3 bis 6 Kohlenstoffatomen, der eine heterocyclische oder kondensierte Ringstruktur bildet, a für 0, 1, 2 oder 3, b für 0, 1 oder 2 und c für 0 oder 1 stehen, wobei die Summe (a + b + c) 3 oder die Wertigkeit des Schwefelatoms beträgt und $X^-$ die in Anspruch 4 angegebene Bedeutung hat.

6. Verfahren nach Anspruch 3, dadurch gekennzeichnet, dass die aromatische Verbindung ein Sulfoxoniumsalz der Formel

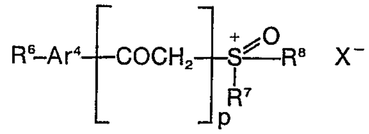 V

oder

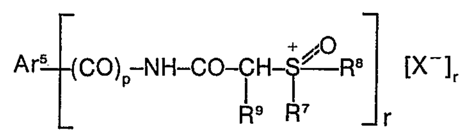 VII

ist, worin p für null oder 1, $Ar^4$ für eine Arylen- oder Aralkylengruppe mit 4 bis 25 Kohlenstoffatomen, welche bei p = 0 direkt über eines ihrer Kohlenstoffatome an das angegebene Schwefelatom bzw. bei p = 1 an das angegebene Carbonylkohlenstoffatom gebunden ist, $R^6$ für ein Wasserstoffatom oder eine Gruppe der Formel

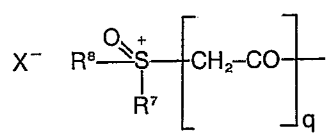 VI

und $R^7$ für eine Alkxylgruppe mit 1 bis 18 Kohlenstoffatomen, eine Alkenylgruppe mit 2 bis 6 Kohlenstoffatomen, eine Cycloalkylgruppe mit 3 bis 4 Kohlenstoffatomen, eine Cycloalkylalkylgruppe mit 4 bis 8 Kohlenstoffatomen, eine Arylgruppe mit 4 bis 24 Kohlenstoffatomen oder eine Aralkylgruppe mit 5 bis 16 Kohlenstoffatomen stehen, $R^8$ dieselbe Bedeutung wie $R^7$ hat, aber auch eine Dialkylaminogruppe mit 2 bis 6 Kohlenstoffatomen oder, falls $R^7$ eine Alkylgruppe wie oben bedeutet, auch eine Arylaminogruppe mit 4 bis 8 Kohlenstoffatomen darstellen kann, q bei p = 0 null oder bei p = 1 null oder 1 ist, $X^-$ die in Anspruch 4 angegebene Bedeutung hat, r 1 oder 2 ist, $Ar^5$ für eine r-wertige aromatische Gruppe mit 4 bis 25 Kohlenstoffatomen, welche bei p = 1 direkt über eines ihrer Kohlenstoffatome an das Kohlenstoffatom der angegebenen, danebenliegenden Carbonylgruppe bzw. bei p = null an das angegebene Stickstoffatom gebunden ist, und $R^9$ für ein Wasserstoffatom oder eine Gruppe der Formel

$$-COR^{11} \qquad VIII$$

oder

$$-CO-NH-(CO)_t-R^{12} \qquad IX$$

stehen, worin $R^{11}$ einen einwertigen, direkt über eines seiner Kohlenstoffatome an die in der Formel VIII gezeigte –CO-Gruppe gebundenen, gesättigten oder äthylenisch ungesättigten Rest mit 1 bis 12 Kohlenstoffatomen, t null oder 1 und $R^{12}$ einen einwertigen, gesättigten oder äthylenisch ungesättigten Rest mit 1 bis 12 Kohlenstoffatomen bedeuten, welcher bei t = null direkt über eines seiner Kohlenstoffatome an das angegebene Stickstoffatom bzw. bei t = 1 an das Kohlenstoffatom der angegebenen, danebenliegenden Carbonylgruppe gebunden ist.

7. Verfahren nach Anspruch 1 oder 2, dadurch gekennzeichnet, dass die aromatische Verbindung ein N-Sulfonyloxyimid der Formel

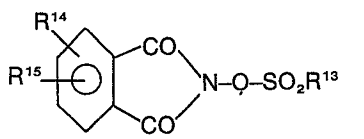

X

oder der Formel

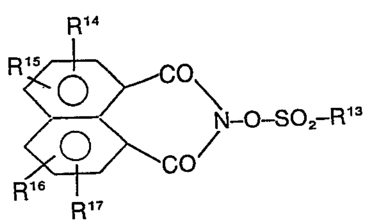

XI

ist, worin $R^{13}$ für eine Alkylgruppe mit 1 bis 12 Kohlenstoffatomen, eine gegebenenfalls durch eine Alkylgruppe mit 1 bis 12 Kohlenstoffatomen, eine Alkoxygruppe mit 1 bis 4 Kohlenstoffatomen, ein Halogenatom, eine Nitrogruppe, eine Alkylcarbamoylgruppe mit insgesamt 2 bis 5 Kohlenstoffatomen oder eine Phenylcarbamoylgruppe substituierte Phenylgruppe, ein mit gegebenenfalls durch eine Alkylgruppe mit 1 bis 12 Kohlenstoffatomen oder ein Halogenatom substituierte Naphthylgruppe, eine Cycloalkylgruppe mit 5 bis 7 Kohlenstoffatomen oder eine Gruppe der Formel $-CF_3$, $CCl_3$ oder $-CH_2Cl$ sowie $R^{14}$ bis $R^{17}$ unabhängig voneinander je für Wasserstoff, eine Alkylgruppe mit 1 bis 8 Kohlenstoffatomen, eine Alkoxygruppe mit 1 bis 4 Kohlenstoffatomen, eine Alkylthiogruppe mit 1 bis 12 Kohlenstoffatomen, eine Phenylthiogruppe, eine Nitrogruppe oder ein Halogenatom stehen.

8. Verfahren nach Anspruch 1 oder 2, dadurch gekennzeichnet, dass die aromatische Verbindung ein Sulfonsäureester eines β-Hydroxypropiophenons der allgemeinen Formel

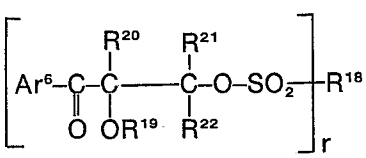

XII

ist, worin r die in Anspruch 6 angegebene Bedeutung hat, $Ar^6$ für eine gegebenenfalls durch eine oder mehrere Alkyl- oder Alkoxygruppen mit 1 bis 8 Kohlenstoffatomen, ein oder mehrere Halogenatome oder eine gegebenenfalls durch eine Hydroxylgruppe substituierte Dialkylaminogruppe mit je 1 bis 4 Kohlenstoffatomen in den Alkylgruppen substituierte aromatische Gruppe mit 6 bis 14 Kohlenstoffatomen, $R^{18}$ bei r = 1 für eine Alkylgruppe mit 1 bis 18 Kohlenstoffatomen, eine Alkenylgruppe mit 2 bis 18 Kohlenstoffatomen, eine Cycloalkyl- oder Cycloalkenylgruppe mit 5 bis 18 Kohlenstoffatomen, eine gegebenenfalls durch ein Chloratom, eine Hydroxylgruppe, eine Alkylgruppe mit 1 bis 12 Kohlenstoffatomen oder eine Alkoxygruppe mit 1 bis 4 Kohlenstoffatomen substituierte Arylgruppe mit 6 bis 12 Kohlenstoffatomen, eine Cycloalkylgruppe mit 5 bis 6 Kohlenstoffatomen, eine Aralkylgruppe mit 7 bis 9 Kohlenstoffatomen, Trifluormethyl, Fluor oder eine Aminogruppe sowie bei r = 2 für eine Gruppe $-(CH_2)_n-$, wobei n eine ganze Zahl von 2 bis 8 ist, oder eine gegebenenfalls durch eine Alkyl- oder Alkylengruppe mit 1 bis 12 Kohlenstoffatomen substituierte Phenylen- oder Aralkylengruppe, $R^{19}$ für ein Wasserstoffatom, eine Alkylgruppe mit 1 bis 18 Kohlenstoffatomen, eine Alkenylgruppe mit 2 bis 18 Kohlenstoffatomen, eine Trimethylsilylgruppe, eine Acetylgruppe, eine Cycloalkyl- oder Cycloalkenylgruppe mit 5 bis 8 Kohlenstoffatomen, eine Arylgruppe mit 6 bis 20 Kohlenstoffatomen, eine Furfurylgruppe oder eine Gruppe $-CH(R^{23})OR^{24}$, in der $R^{23}$ eine Methylgruppe und $R^{24}$ eine Alkylgruppe mit 2 bis 4 Kohlenstoffatomen oder $R^{23}$ und $R^{24}$ zusammen eine gegebenenfalls durch eine Alkoxygruppe mit 1 bis 4 Kohlenstoffatomen substituierte 1,3- oder 1,4-Alkylengruppe mit 3 bis 4 Kohlenstoffatomen darstellen, und $R^{20}$ für ein Wasserstoffatom, ein gegebenenfalls durch eine oder mehrere Alkyl- oder Alkoxygruppen mit 1 bis 4 Kohlenstoffatomen oder ein oder mehrere Halogenatome substituierte aromatische Gruppe mit 6 bis 14 Kohlenstoffatomen oder eine gegebenenfalls durch eine Phenylgruppe substituierte Alkylgruppe mit 1 bis 8 Kohlenstoffatomen stehen sowie $R^{21}$ und $R^{22}$ unabhängig voneinander je ein Wasserstoffatom, eine Alkylgruppe mit 1 bis 8 Kohlenstoffatomen oder eine gegebenenfalls durch ein Chloratom, eine Hydroxylgruppe oder eine Alkyl- oder Alkoxygruppe mit 1 bis 4 Kohlenstoffatomen substituierte Phenylgruppe bedeuten können oder $R^{20}$ und $R^{21}$ zusammen mit dem Kohlenstoffatom, an das sie gebunden sind, einen 5- oder 6-gliedrigen Ring bilden.

9. Verfahren nach Anspruch 8, dadurch gekennzeichnet, dass die aromatische Verbindung ein Sulfonsäureester eines α-Methylolbenzoins der allgemeinen Formel

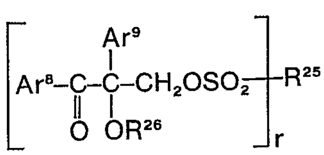

XIII

ist, worin r die in Anspruch 6 angegebene Bedeutung hat, $Ar^8$ und $Ar^9$ gleich oder verschieden sein können und je für ein gegebenenfalls durch eine oder mehrere Alkylgruppen mit 1 bis 4 Kohlenstoffatomen, eine oder mehrere Alkoxygruppen

mit 1 bis 4 Kohlenstoffatomen oder ein oder mehrere Halogenatome substituierte aromatische Gruppe mit 6 bis 14 Kohlenstoffatomen, $R^{25}$ für eine Alkyl- oder Alkylengruppe mit 1 bis 6 Kohlenstoffatomen, eine Arylgruppe mit 6 bis 12 Kohlenstoffatomen oder eine Aralkylengruppe mit 6 bis 15 Kohlenstoffatomen und $R^{26}$ für ein Wasserstoffatom oder eine Alkylgruppe mit 1 bis 4 Kohlenstoffatomen stehen.

10. Verfahren nach Anspruch 1 oder 2, dadurch gekennzeichnet, dass die aromatische Verbindung ein Sulfonsäureester eines o-Hydroxyacylophenons der allgemeinen Formel

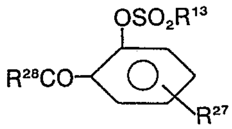

XVII

ist, worin $R^{13}$ die in Anspruch 7 angegebene Bedeutung hat, $R^{27}$ für ein Wasserstoffatom, ein Halogenatom, eine Nitrogruppe, eine Alkylgruppe mit 1 bis 12 Kohlenstoffatomen, eine Alkoxygruppe mit 1 bis 4 Kohlenstoffatomen oder eine Gruppe der Formel $-OSO_2R^{13}$ und $R^{28}$ für eine Alkylgruppe mit 1 bis 4 Kohlenstoffatomen, eine Phenylgruppe oder eine Gruppe der Formel

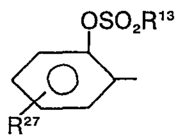

XVIII

stehen.

11. Verfahren nach Anspruch 1 oder 2, dadurch gekennzeichnet, dass die aromatische Verbindung ein o-Nitrobenzaldehyd der Formel

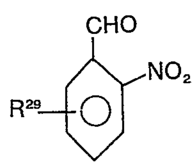

XIX

ist, worin $R^{29}$ für ein Wasserstoffatom oder eine Nitrogruppe steht.

12. Verfahren nach Anspruch 1 oder 2, dadurch gekennzeichnet, dass die aromatische Verbindung ein α-Chloracylphenon oder α-Bromacylphenon der Formel

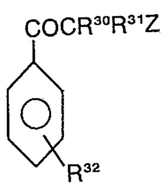

XX

ist, worin Z für ein Chlor- oder Bromatom, $R^{30}$ und $R^{31}$ unabhängig voneinander je für ein Wasserstoff-, Chlor- oder Bromatom und $R^{32}$ für ein Wasserstoffatom oder eine Gruppe der Formel

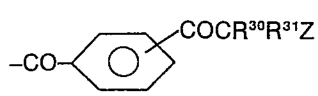

XXI

stehen.

13. Verfahren nach einem der vorhergehenden Ansprüche, dadurch gekennzeichnet, dass die Photoresistzusammensetzung so viel benzoides Polyamin enthält, dass 0,7 bis 1,1 aromatische Aminwasserstoffatome auf eine 1,2-Epoxidgruppe im Epoxidharz kommen.

14. Verfahren nach einem der vorhergehenden Ansprüche, dadurch gekennzeichnet, dass die Photoresistzusammensetzung 5 bis 30 Gew.-%, berechnet auf das Gewicht des Epoxidharzes, der aromatischen Verbindung enthält.

**Claims**

1. A process for the preparation of an image on a substrate by exposing imagewise to actinic radiation a layer of a photoresist composition on the substrate, heating the composition on the substrate such that the part or parts of the composition which have been struck by the radiation are substantially cured whereas the part or parts thereof which have not been so struck remain substantially uncured, and then treating the composition on the substrate with a solvent developer to remove the part or parts of the composition which remain substantially uncured, the photoresist composition comprising an epoxide resin and an effective amount of a benzenoid polyamine, and further comprising an aromatic compound which liberates an acid on exposure to actinic radiation, selected from

(a) chlorides, bromides, and iodides of onium bases of elements in Group VA, VIA, or VIIA of the Periodic Table,
(b) N-sulphonyloxyimides, and esters of sulphonic acids with β-hydroxypropiophenones or with o-hydroxyacylphenones,
(c) o-nitrobenzaldehydes, and
(d) α-chloroacylphenones and α-bromoacylphenones.

2. A process according to claim 1, in which the benzenoid polyamine (i) is o-, m-, or p-phenylenediamine, bis(4-aminophenyl)methane, an aniline-formaldehyde resin, bis(4-aminophenyl) ether, bis(4-aminophenyl) ketone, bis(4-aminophenyl) sulphide, bis(3-aminophenyl) sulphone, or bis(4-aminophenyl) sulphone.

3. A process according to claim 1 or 2, in which the aromatic compound is a diazonium, phosphonium, arsonium, oxonium, sulphonium, sulphoxonium, selenonium, telluronium, chloronium, bromonium, or iodonium chloride, bromide, or iodide.

4. A process according to claim 3, in which the aromatic compound is an iodonium salt of formula

$$\left[Ar^1-\overset{+}{I}-Ar^2\right] X^- \qquad II$$

wherein $Ar^1$ and $Ar^2$ are each independently of the other phenyl or naphthyl, which may each be substituted by one or more alkyl groups of 1 to 8 carbon atoms, by phenyl, by phenoxy, by halogen, by nitro, or by one or more alkoxy groups each of

1 to 4 carbon atoms, or $Ar^1$ and $Ar^2$ together are a group of formula

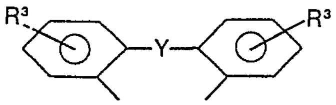

wherein $R^3$ is an alkyl group of 1 to 4 carbon atoms, a halogen atom, a nitro group, or an alkoxy group of 1 to 4 carbon atoms, Y denotes a carbon-carbon bond, an oxygen atom, or a group of formula $-CH_2-$ or $-CO-$, and $X^-$ denotes a chloride, bromide, or iodide anion.

5. A process according to claim 3, in which the aromatic compound is a sulphonium salt of formula

$$Ar^3_aR^4_bR^5_c\overset{+}{S} \quad X^- \qquad IV$$

wherein $Ar^3$ is a monovalent aromatic group of 6 to 20 carbon atoms, $R^4$ is an alkyl group of 1 to 6 carbon atoms or a cycloalkyl group of 3 to 6 carbon atoms, which alkyl or cycloalkyl group may be substituted by an alkoxy group of 1 to 4 carbon atoms or by an alkoxycarbonyl group of 2 to 5 carbon atoms, $R^5$ is a polyvalent aliphatic or aromatic radical of 3 to 6 carbon atoms forming a heterocyclic or fused ring structure, a is 0, 1, 2, or 3, b is 0, 1, or 2, c is 0 or 1, the sum of (a + b + c) being 3 or the valency of the sulphur atom, and $X^-$ has the meaning assigned in claim 4.

6. A process according to claim 3, in which the aromatic compound is a sulphoxonium salt of formula

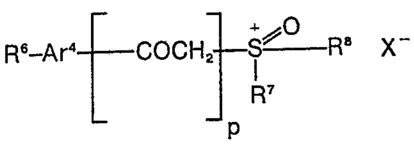

V

or

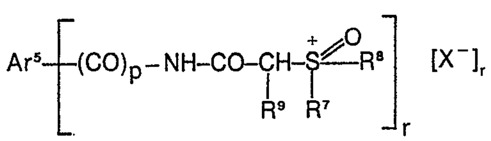

VII

wherein p is zero or 1, $Ar^4$ is an arylene or aralkylene group of 4 to 25 carbon atoms linked directly through a carbon atom thereof, if p denotes zero, to the indicated sulphur atom or, if p denotes 1, to the indicated carbonyl carbon atom, $R^6$ is a hydrogen atom or a group of formula

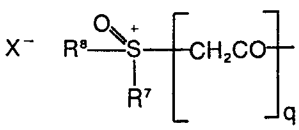

VI

$R^7$ is an alkyl group of 1 to 18 carbon atoms, an alkenyl group of 2 to 6 carbon atoms, a cycloalkyl group of 3 to 4 carbon atoms, a cycloalkylalkyl group of 4 to 8 carbon atoms, an aryl group of 4 to 24 carbon atoms, or an aralkyl group of 5 to 16 carbon atoms, $R^8$ has the same meaning as $R^7$ but may alternatively be a dialkylamino group of 2 to 6 carbon atoms or, if $R^7$ is a said alkyl group, may alternatively represent an arylamino group of 4 to 8 carbon atoms, q is zero when p denotes zero, or zero or 1 when p denotes 1, $X^-$ has the meaning assigned in claim 4, r is 1 or 2, $Ar^5$ is an aromatic group of valency r, having from 4 to 25 carbon atoms and being linked direct through a carbon atom thereof to the carbon atom of the indicated adjacent carbonyl group if p is 1 or to the indicated nitrogen atom if p is zero, $R^9$ is a hydrogen atom or a group of formula

$$-COR^{11} \qquad VIII$$

or

$$-CO-NH-(CO)_t-R^{12} \qquad IX$$

wherein $R^{11}$ is a monovalent saturated or ethylenically unsaturated radical of 1 to 12 carbon atoms, linked direct through a carbon atom thereof to the $-CO-$ group shown in formula VIII, t is zero or 1, and $R^{12}$ is a monovalent saturated or ethylenically unsaturated radical of 1 to 12 carbon atoms, linked direct through a carbon atom thereof to, if t denotes zero, the indicated nitrogen atom, or, if t denotes 1, the carbon atom of the indicated adjacent carbonyl group.

7. A process according to claim 1 or 2, in which the aromatic compound is an N-sulphonyloxyimide of formula

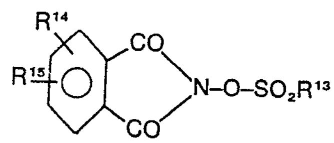

X

or of formula

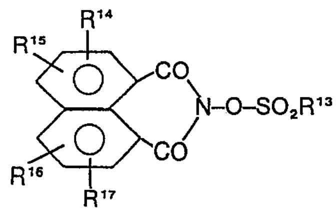

XI

wherein $R^{13}$ is an alkyl group of 1 to 12 carbon atoms; a phenyl group which may be substituted by an alkyl group of 1 to 12 carbon atoms, an alkoxy group of 1 to 4 carbon atoms, a halogen atom, a nitro group, an alkylcarbamoyl group of 2 to 5 carbon atoms in all, or by a phenylcarbamoyl group; a naphthyl group which may be substituted by an alkyl group of 1 to 12 carbon atoms or by a halogen atom; a cycloalkyl group of 5 to 7 carbon atoms; or a group of formula $-CF_3$, $-CCl_3$, or $-CH_2Cl$, and $R^{14}$ to $R^{17}$ are each independently hydrogen, an alkyl group of 1 to 8 carbon atoms, an alkoxy group of 1 to 4 carbon atoms, an alkylthio group of 1 to 12 carbon atoms, a phenylthio group, or a nitro group, or a halogen atom.

8. A process according to claim 1 or 2, in which the aromatic compound is a sulphonic ester of a β-hydroxypropiophenone, having the general formula

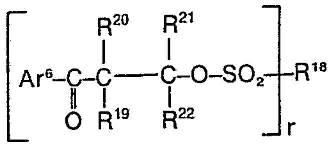

XII

wherein r has the meaning assigned in claim 6, $Ar^6$ is an aromatic group of 6 to 14 carbon atoms which may be substituted by one or more alkyl or alkoxy groups of 1 to 8 carbon atoms, by one or more halogen atoms, or by a dialkylamino group in which the alkyl groups have from 1 to 4 carbon atoms and which may be substituted by a hydroxyl group, when r denotes 1, then $R^{18}$ is an alkyl group of 1 to 18 carbon atoms, an alkenyl group of 2 to 18 carbon atoms, a cycloalkyl or cycloalkenyl group of 5 to 8 carbon atoms, an aryl group of 6 to 12 carbon atoms which may be substituted by a chlorine atom, a hydroxy group, an alkyl group of 1 to 12 carbon atoms, or by an alkoxy group of 1 to 4 carbon atoms, or is a cycloalkyl group of 5 or 6 carbon atoms, an aralkyl group of 7 to 9 carbon atoms, trifluoromethyl, fluoro, or an amino group, when r represents 2, then $R^{18}$ is a group $-(CH_2)_n-$ in which n is an integer from 2 to 8, or a phenylene or aralkylene group, either of which may be substituted by an alkyl or alkylene group of 1 to 12 carbon atoms, $R^{19}$ is a hydrogen atom, an alkyl group of 1 to 18 carbon atoms, an alkenyl group of 2 to 18 carbon atoms, a trimethylsilyl group, an acetyl group, a cycloalkyl or cycloalkenyl group of 5 to 8 carbon atoms, an aryl group of 6 to 20 carbon atoms, a furfuryl group, or a group $-CH(R^{23})OR^{24}$ in which $R^{23}$ is a methyl group and $R^{24}$ is an alkyl group of 2 to 4 carbon atoms or $R^{23}$ and $R^{24}$ together represent a 1,3- or 1,4-alkylene group having 3 or 4 carbon atoms and which may be substituted by an alkoxy group of 1 to 4 carbon atoms, $R^{20}$ is a hydrogen atom, an aromatic group of 6 to 14 carbon atoms which may be substituted by one or more alkyl or alkoxy groups of 1 to 4 carbon atoms or by one or more halogen atoms, or is an alkyl group of 1 to 8 carbon atoms which may be substituted by a phenyl group, $R^{21}$ and $R^{22}$ may each independently be a hydrogen atom, an alkyl group of 1 to 8 carbon atoms, a phenyl group which may be substituted by a chlorine atom, a hydroxy group, or an alkyl or alkoxy group of 1 to 4 carbon atoms, or $R^{20}$ and $R^{21}$, together with the carbon atoms to which they are attached, form a 5- or 6-membered carbocyclic ring.

9. A process according to claim 8, in which the aromatic compound is a sulphonic ester of an α-methylolbenzoin, having the general formula

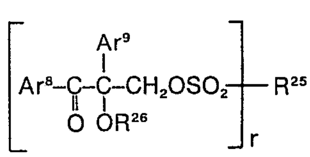

XIII

wherein r has the meaning assigned in claim 6, $Ar^8$ and $Ar^9$ may be the same or different and each is an aromatic group of 6 to 14 carbon atoms which may be substituted by one or more alkyl groups of 1 to 4 carbon atoms, by one or more alkoxy groups of 1 to 4 carbon atoms, or by one or more halogen atoms, $R^{25}$ is an alkyl or alkylene group of 1 to 6 carbon atoms, an aryl group of 6 to 12 carbon atoms, or an aralkylene group of 6 to 15 carbon atoms, and $R^{26}$ is a hydrogen atom or an alkyl group of 1 to 4 carbon atoms.

10. A process according to claim 1 or 2, in which the aromatic compound is a sulphonic ester of an o-hydroxyacylophenone having the general formula

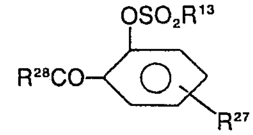

XVII

wherein $R^{13}$ has the meaning assigned in claim 7, $R^{27}$ is a hydrogen atom, a halogen atom, a nitro group, an alkyl group of 1 to 12 carbon atoms, an alkoxy group of 1 to 4 carbon atoms, or a group of formula $-OSO_2R^{13}$, and $R^{28}$ is an alkyl group of 1 to 4 carbon atoms, a phenyl group, or a group of formula

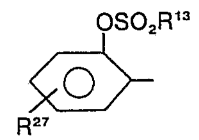

XVIII

11. A process according to claim 1 or 2, in which the aromatic compound is an o-nitrobenzaldehyde of formula

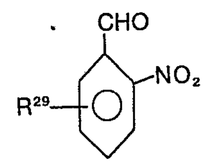

XIX

where $R^{29}$ is a hydrogen atom or a nitro group.

12. A process according to claim 1 or 2, in which the aromatic compound is an α-chloroacylphenone or an α-bromoacylphenone of formula

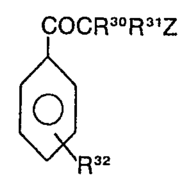

XX

wherein Z is a chlorine or bromine atom, $R^{30}$ and $R^{31}$ are each independently a hydrogen, chlorine, or bromine atom, and $R^{32}$ is a hydrogen atom, an alkyl group of 1 to 6 carbon atoms, or a group of formula

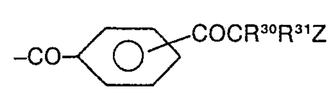

XXI

13. A process according to any one of the preceding claims, wherein the photoresist composition contains sufficient of the benzenoid polyamine to supply from 0.7 to 1.1 aromatic amino hydrogen atoms per 1,2-epoxide group in the epoxide resin.

14. A process according to any one of the preceding claims, wherein the photoresist composition contains from 5 to 30% by weight of the aromatic compound, calculated on the weight of the epoxide resin.

**Revendications**

1. Procédé pour créer des images sur un substrat, selon lequel on expose à un rayonnement actinique, conformément à une image, une couche d'une composition de photoréserve appliquée sur le substrat, on chauffe la composition sur le substrat de telle sorte que la ou les parties de la composition qui ont été touchées par le rayonnement soient durcies dans une large mesure tandis que la ou les parties non touchées échappent presque totalement au durcissement, puis on traite la composition sur le substrat par un solvant révélateur pour éliminer la ou les parties qui sont restées à l'état pratiquement non durci, et selon lequel la composition de photoréserve contient une résine époxydique et une quantité efficace d'une polyamine benzénoïde, ce procédé étant caractérisé en ce que ladite composition renferme en outre une quantité efficace d'un composé aromatique qui libère un acide au cours de l'exposition à un rayonnement actinique et qui est choisi dans les classes de composés suivantes:

(a) les chlorures, bromures et iodures de bases d'oniums des éléments des groupes Va, VIa et VIIa de la classification périodique,
(b) les N-sulfonyloxy-imides et les esters d'acides sulfoniques avec des β-hydroxy-propiophénones ou des o-hydroxy-acylphénones,
(c) les o-nitrobenzaldéhydes et
(d) les α-chloracylphénones et les α-bromacylphénones.

2. Procédé selon la revendication 1, caractérisé en ce que la polyamide benzénoïde est l'o-, la m- ou la p-phénylène-diamine, le bis-(amino-4 phényl)-méthane, une résine aniline/formaldéhyde, l'oxyde de bis-(amino-4 phényle), la bis-(amino-4 phényl)-cétone, le sulfure de bis-(amino-4 phényle), la bis-(amino-3 phènyl)-sulfone ou la bis-(amino-4 phényl)-sulfone.

3. Procédé selon l'une des revendications 1 et 2 caractérisé en ce que le composé aromatique est un chlorure, un bromure ou un iodure de diazonium, de phosphonium, d'arsonium, d'oxonium, de sulfonium, de sulfoxonium, de sélénonium, de telluronium, de chloronium, de bromonium ou d'iodonium.

4. Procédé selon la revendication 3 caractérisé en ce que le composé aromatique est un sel d'iodonium répondant à la formule II:

$$\left[Ar^1-\overset{+}{I}-Ar^2\right]\ X^- \qquad \text{II}$$

dans laquelle $Ar^1$ et $Ar^2$ représentent chacun, indépendamment l'un de l'autre, un radical phényle ou naphtyle éventuellement porteur d'un ou plusieurs alkyles contenant de 1 à 8 atomes de carbone, d'une phényle, d'un phénoxy, d'un halogène, d'un nitro ou d'un ou plusieurs alcoxy contenant chacun de 1 à 4 atomes de carbone, ou encore $Ar^1$ et $Ar^2$ forment ensemble un radical répondant à la formule III:

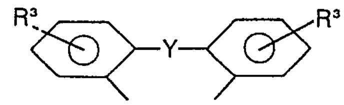

III

dans laquelle $R^3$ représente un radical alkyle contenant de 1 à 4 atomes de carbone, un atome d'halogène, un radical nitro ou un radical alcoxy contenant de 1 à 4 atomes de carbone et Y représente une liaison carbone-carbone, un atome d'oxygène ou un radical $-CH_2-$ ou $-CO-$, et $X^-$ représente un anion chlorure, bromure ou iodure.

5. Procédé selon la revendication 3 caractérisé en ce que le composé aromatique est un sel de sulfonium répondant à la formule IV:

$$Ar^3{}_aR^4{}_bR^5{}_c\overset{+}{S}\ \ X^- \qquad \text{IV}$$

dans laquelle $Ar^3$ représente un radical aromatique univalent qui contient de 6 à 20 atomes de carbone, $R^4$ représente un radical alkyle contenant de 1 à 6 atomes de carbone ou un radical cycloalkyle contenant de 3 à 6 atomes de carbone, le radical alkyle ou cycloalkyle portant éventuellement un radical alcoxy en $C_1$–$C_4$ ou un radical alcoxycarbonyle en $C_2$–$C_5$, $R^5$ représente un radical aliphatique ou aromatique multivalent qui contient de 3 à 6 atomes de carbone et qui forme un hétérocycle ou une structure cyclique condensée, a est égal à 0, à 1, à 2 ou à 3, b est égal à 0, à 1 ou à 2 et c est égal à 0 ou à 1, la somme (a + b + c) étant égale à 3 ou à la valence de l'atome de soufre, et $X^-$ a la signification donnée à la revendication 4.

6. Procédé selon la revendication 3 caractérisé en ce que le composé aromatique est un sel de sulfoxonium répondant à l'une des formules V et VII:

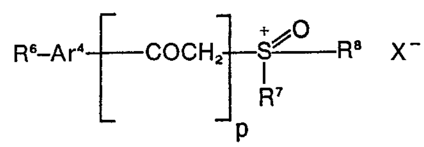

V

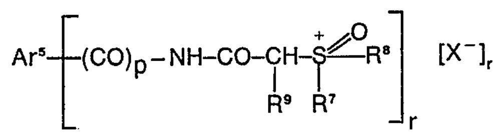

VII

dans lesquelles p est égal à 0 ou à 1, $Ar^4$ représente un radical arylène ou aralkylène contenant de 4 à 25 atomes de carbone, radical qui est lié directement, c'est-à-dire par l'un de ses atomes de carbone, à l'atome de soufre représenté dans le cas où p est égal à 0, ou à l'atome de carbone carbonylique représenté dans le cas où p est égal à 1, $R^6$ représente un atome d'hydrogène ou un radical de formule VI:

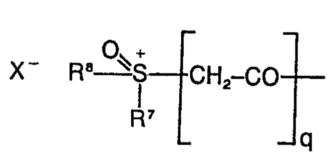

VI

$R^7$ représente un radical alkyle contenant de 1 à 18 atomes de carbone, un radical alcényle contenant de 2 à 6 atomes de carbone, un radical cycloalkyle contenant 3 ou 4 atomes de carbone, un radical cycloalkyl-alkyle contenant de 4 à 8 atomes de carbone, un radical aryle contenant de 4 à 24 atomes de carbone ou un radical aralkyle contenant de 5 à 16 atomes de carbone, $R^8$ a la même signification que $R^7$ mais peut aussi représenter un radical dialkylamino contenant de 2 à 6 atomes de carbone ou, dans le cas où $R^7$ désigne un alkyle tel que défini ci-dessus, $R^8$ peut aussi représenter un radical arylamino contenant de 4 à 8 atomes de carbone, q est égal à 0 lorsque p est lui-même égal à 0 ou q est égal à 0 ou à 1 lorsque p est égal à 1, $X^-$ a la signification donnée à la revendication 4, r est égal à 1 ou à 2, $Ar^5$ représente un radical aromatique de valence r qui contient de 4 à 25 atomes de carbone et qui est lié, dans le cas où p est égal à 1, directement, par l'un de ses atomes de carbone, à l'atome de carbone du radical carbonyle adjacent représenté ou, dans le cas où p est égal à 0, à l'atome d'azote représenté, et $R^9$ représente un atome d'hydrogène ou un radical répondant à l'une des formules VIII et IX:

$$-COR^{11} \qquad \text{(VIII)}$$

ou

$$-CO-NH-(CO)_t-R^{12} \qquad \text{(IX)}$$

dans lesquelles $R^{11}$ représente un radical univalent saturé ou éthylénique, qui contient de 1 à 12 atomes de carbone et qui est lié directement, par l'un de ses atomes de carbone, au radical -CO- représenté sur la formula VIII, t est égal à 0 ou à 1 et $R^{12}$ représente un radical univalent, saturé ou éthylénique, qui contient de 1 à 12 atomes de carbone, ce radical étant lié, dans le cas où t est égal à 0, directement, par l'un de ses atomes de carbone, à l'atome d'azote représenté, ou, dans le cas où t est égal à 1, à l'atome de carbone du radical carbonyle adjacent représenté.

7. Procédé selon l'une des revendications 1 et 2 caractérisé en ce que le composé aromatique est un N-sulfonyloxy-imide répondant à l'une des formules X et XI:

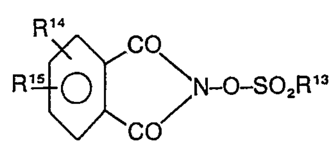

X

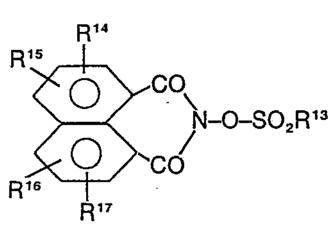

XI

dans lesquelles $R^{13}$ représente un radical alkyle contenant de 1 à 12 atomes de carbone, un radical phényle éventuellement porteur d'une alkyle en $C_1$–$C_{12}$, d'une alcoxy en $C_1$–$C_4$, d'une atome d'halogène, d'un nitro, d'un alkylcarbamoyle contenant au total de 2 à 5 atomes de carbone ou d'un phénylcarbamoyle, un radical naphtyle éventuellement porteur d'un alkyle en $C_1$–$C_{12}$ ou d'un atome d'halogène, un radical cycloalkyle contenant de 5 à 7 atomes de carbone ou un radical $-CF_3$, $-CCl_3$ ou $-CH_2Cl$, tandis que $R^{14}$ à $R^{17}$ représentent chacun, indépendamment les uns des autres, un atome d'hydrogène, un radical alkyle contenant de 1 à 8 atomes de carbone, un radical alcoxy contenant de 1 à 4 atomes de carbone, un radical alkylthio contenant de 1 à 12 atomes de carbone, un radical phénylthio, un radical nitro ou un atome d'halogène.

8. Procédé selon l'une des revendications 1 et 2 caractérisé en ce que le composé aromatique est un ester sulfonique d'une β-hydroxy-propiophénone répondant à la formule générale XII:

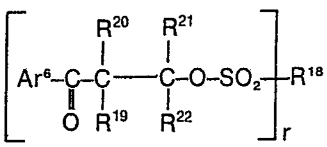

XII

dans laquelle r a la signification donnée à la revendication 6, $Ar^6$ représente un radical aromatique contenant de 6 à 14 atomes de carbone, éventuellement porteur d'un ou de plusieurs radicaux alkyles ou alcoxy en $C_1$–$C_8$, d'un ou de plusieurs atomes d'halogènes ou d'un radical dialkylamino contenant, dans chacun de ses radicaux alkyles, de 1 à 4 atomes de carbone et portant éventuellement un radical hydroxy, $R^{18}$ représente, dans le cas où r est égal à 1, un radical alkyle contenant de 1 à 18 atomes de carbone, un radical alcényle contenant de 2 à 18 atomes de carbone, un radical cycloalkyle ou cycloalcényle contenant de 5 à 18 atomes de carbone, un radical aryle contenant de 6 à 12 atomes de carbone, éventuellement porteur d'un atome de chlore, d'un radical hydroxy, d'un radical alkyle en $C_1$–$C_{12}$ ou d'un radical alcoxy en $C_1$–$C_4$, un radical cycloalkyle contenant 5 ou 6 atomes de carbone, un radical aralkyle contenant de 7 à 9 atomes de carbone, un radical trifluorométhyle, un atome de fluor ou un radical amino, et, dans le cas où r est égal à 2, un radical $-(CH_2)_n-$ dont l'indice n désigne un nombre entier de 2 à 8, ou un radical phénylène ou aralkylène éventuellement porteur d'un radical alkyle ou alkylène en $C_{1-12}$, $R^{19}$ représente un atome d'hydrogène, un radical alkyle contenant de 1 à 18 atomes, de carbone, un radical alcényle contenant de 2 à 18 atomes de carbone, un radical triméthylsilyle, un radical acétyle, un radical cycloalkyle ou cycloalcényle contenant de 5 à 8 atomes de carbone, un radical aryle contenant de 6 à 20 atomes de carbone, un radical furfuryle ou un radical $-CH(R^{23})OR^{24}$ dans lequel $R^{23}$ représente un radical méthyle et $R^{24}$ un radical alkyle contenant de 2 à 4 atomes de carbone, ou $R^{23}$ et $R^{24}$ forment ensemble un radical alkylène-1,3 ou -1,4 contenant 3 ou 4 atomes de carbone et portant éventuellement un radical alcoxy en $C_1$–$C_4$, $R^{20}$

représente un atome d'hydrogène, un radical aromatique contenant de 6 à 14 atomes de carbone, éventuellement porteur d'un ou de plusieurs radicaux alkyles ou alcoxy en $C_1$–$C_4$ ou d'un ou de plusieurs atomes d'halogènes, ou un radical alkyle contenant de 1 à 8 atomes de carbone, éventuellement porteur d'un phényle, et $R^{21}$ et $R^{22}$ peuvent représenter chacun, indépendamment l'un de l'autre, un atome d'hydrogène, un radical alkyle contenant de 1 à 8 atomes de carbone ou un radical phényle éventuellement porteur d'un atome de chlore, d'un radical hydroxy ou d'un radical alkyle ou alcoxy en $C_1$–$C_4$, ou $R^{20}$ et $R^{21}$ forment ensemble, et avec l'atome de carbone auquel ils sont liés, un carbocycle à 5 ou à 6 maillons.

9. Procédé selon la revendication 8 caractérisé en ce que le composé aromatique est un ester sulfonique d'une α-méthylol-benzoïne répondant à la formule générale XIII:

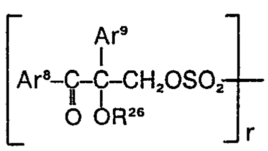

XIII

dans laquelle r a la signification donnée à la revendication 6, $Ar^8$ et $Ar^9$ représentent chacun, indépendamment l'un de l'autre, un radical aromatique qui contient de 6 à 14 atomes de carbone et qui porte éventuellement un ou plusieurs radiocaux alkyles contenant de 1 à 4 atomes de carbone, un ou plusieurs radicaux alcoxy contenant de 1 à 4 atomes de carbone ou un ou plusieurs atomes d'halogènes, $R^{25}$ représente un radical alkyle ou alkylène contenant de 1 à 6 atomes de carbone, un radical aryle contenant de 6 à 12 atomes de carbone ou un radical aralkylène contenant de 6 à 15 atomes de carbone, et $R^{26}$ représente un atome d'hydrogène ou un radical alkyle contenant de 1 à 4 atomes de carbone.

10. Procédé selon l'une des revendications 1 et 2, caractérisé en ce que le composé aromatique est un ester sulfonique d'une o-hydroxy-acylphénone répondant à la formule générale XVII:

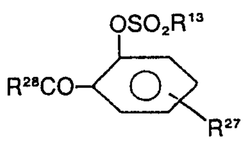

XVII

dans laquelle $R^{13}$ a la signification donnée à la revendication 7, $R^{27}$ représente un atome d'hydrogène, un atome d'halogène, un radical nitro, un radical alkyle contenant de 1 à 12 atomes de carbone, un radical alcoxy contenant de 1 à 4 atomes de carbone ou un radical de formule $-OSO_2R^{13}$, et $R^{28}$ représente un radical alkyle contenant de 1 à 4 atomes de carbone, un radical phényle ou un radical de formule XVIII:

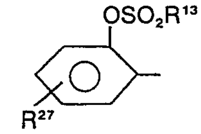

XVIII

11. Procédé selon l'une des revendications 1 et 2 caractérisé en ce que le composé aromatique est un o-nitro-benzaldéhyde répondant à la formule XIX:

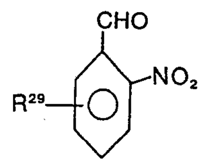

XIX

dans laquelle $R^{29}$ représente un atome d'hydrogène ou un radical nitro.

12. Procédé selon l'une des revendications 1 et 2 caractérisé en ce que le composé aromatique est une α-chloracylphénone ou une α-bromacylphénone répondant à la formule XX:

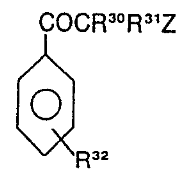

XX

dans laquelle Z représente un atome de chlore ou de brome, $R^{30}$ et $R^{31}$ représentent chacun, indépendamment l'un de l'autre, un atome d'hydrogène, de chlore ou de brome et $R^{32}$ représente un atome d'hydrogène ou un radical de formule XXI:

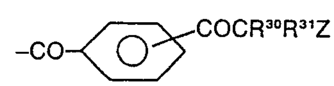

XXI

13. Procédé selon l'une quelconque des revendications précédentes, procédé caractérisé en ce que la composition de photoréserve renferme une quantité d'une polyamine benzénoïde telle qu'il y ait de 0,7 à 1,1 atome d'hydrogène aminé aromatique pour 1 radical époxy-1,2 dans la résine époxydique.

14. Procédé selon l'une quelconque des revendications précédentes caractérisé en ce que la composition de photoréserve contient de 5 à 30% en poids du composé aromatique par rapport au poids de la résine époxydique.